# EUROPEAN PATENT APPLICATION

(11) **EP 4 811 690 A1**
(43) Date of publication of application: **23.09.2026**
(21) Application number: 25742294.9
(22) Date of filing: 20.01.2025
(51) Int. Cl.: H04L 1/00, H03M 13/11

(54) **DEVICE AND METHOD FOR DECODING CHANNEL CODE IN COMMUNICATION SYSTEM OR BROADCASTING SYSTEM**

(30) Priority: 20.01.2024 KR 20240009144; 08.02.2024 KR 20240020019
(71) Applicant: Samsung Electronics Co., Ltd., Suwon-si, Gyeonggi-do 16677 (KR)
(72) Inventor: LEE, Hyunjae, Suwon-si Gyeonggi-do 16677 (KR); JANG, Min, Suwon-si Gyeonggi-do 16677 (KR); MYUNG, Seho, Suwon-si Gyeonggi-do 16677 (KR); LIM, Hyuntack, Suwon-si Gyeonggi-do 16677 (KR); CHOI, Youngkwan, Suwon-si Gyeonggi-do 16677 (KR)
(74) Representative: Gulde & Partner
(86) International application number: PCT/KR2025/001087
(87) International publication number: WO 2025/155146

(57) **Abstract**

In embodiments, provided is an electronic device in a communication system or a broadcasting system. The electronic device may comprise at least one processor, and a memory for storing instructions. The instructions, when executed by the at least one processor, may cause the electronic device to: acquire a signal encoded through a channel code; acquire a first input sequence for the signal; determine a change region in the first input sequence on the basis of a lifting size for the channel code and the number of bits to be encoded in a code block; acquire second candidate input sequences corresponding to combinations in which each value of the change region is different on the basis of the first input sequence; and provide a final decoding result by decoding each candidate input sequence from at least some of the second candidate input sequences.

## Description

### [Technical Field]

The present disclosure relates to a communication system or a broadcasting system. More specifically, the present disclosure relates to a device and a method for decoding a channel code in the communication system or the broadcasting system.

### [Background Art]

In general, in a case that data is transmitted and received between a transmitter and a receiver in a communication and broadcasting system, a performance of a link may be significantly deteriorated by various types of noise, a fading phenomenon, and inter-symbol interference (ISI) existing in a communication channel. Therefore, in order to implement a high-speed digital communication or broadcasting system requiring high throughput and reliability, such as nextgeneration mobile communication, digital broadcasting, and portable Internet, it is required to develop a technique for overcoming the noise, the fading, and the inter-symbol interference. As such, in order to overcome an error that may occur due to the communication channel at the receiver, an error detection codes and an error correcting codes (ECC) scheme is utilized. The error correcting codes used in communication between the transmitter and the receiver is generally also called channel coding, or forward error correction (FEC). The transmitter encodes an information vector to be transmitted to generate and transmit a codeword vector, and the receiver performs a series of processes on a received signal, and then decodes the processed signal to estimate the information vector.

In the communication system and the broadcasting system, various channel coding schemes are used. As a channel coding method used today, a convolutional code, a turbo code, a low-density parity-check coding (LDPC code), and a polar code are included. The turbo code and the LDPC code are channel coding schemes performing iterative decoding, and in a case that a length is long, a performance is particularly excellent, and thus are used in various communication and broadcasting systems.

The turbo code is a first channel coding scheme that has been shown to achieve a performance approaching a channel capacity by using a decoding algorithm having a practical complexity. A turbo code system performs decoding in a manner in which two component decoders, called turbo processing, iteratively pass messages, and such decoding shows an excellent performance particularly when processing information and a codeword vector having a long length. Due to these advantages, the turbo code is adopted and used for processing information of a data channel of 3rd Generation Partnership Project (3GPP) 4th generation (4G) Long-Term Evolution (LTE).

The LDPC code is also a channel coding scheme known to achieve a performance approaching a channel capacity with a decoding algorithm having a practical complexity. In particular, decoding called belief-propagation (BP) is suitable for parallelizing each detailed operation, and thus is advantageous in achieving a high-throughput. Due to these advantages, LDPC codes are used in various communication and broadcasting systems such as IEEE 802.11n/ad Wi-Fi, DVB-T2/C2/S2, and ATSC 3.0, and particularly, are recently adopted and used also in a 3rd Generation Partnership Project (3GPP) New Radio (NR) system, which is a 5th generation (5G) mobile communication system.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among the first input sequence based on a lifting size for the channel code and the number of bits to be encoded in a code block, obtain second candidate input sequences corresponding to combinations having different values in the change area of the first input sequence as a reference of the first input sequence, and provide a final decoding result by decoding each candidate input sequence from at least a portion of the second candidate input sequences.

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among a systematic part and a parity part of the first input sequence based on a result of decoding of belief-propagation for the first input sequence, obtain second candidate input sequences corresponding to combinations having different values in the change area of the first input sequence as a reference of the first input sequence, and provide a final decoding result by decoding each candidate input sequence from at least a portion of the second candidate input sequences.

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among puncturing bits of a systematic part and puncturing bits of a parity part of the first input sequence, obtain second candidate input sequences corresponding to combinations having different values in the change area of the first input sequence as a reference of the first input sequence, and provide a final decoding result by decoding each candidate input sequence from at least a portion of the second candidate input sequences.

In embodiments, a decoding method for a channel code in a communication system is provided. The method may comprise a step of receiving a signal encoded with a channel code that is used, and transmitted, a step of generating a first decoder input sequence (or a vector, an array, and the like) from the signal, a step of generating at least one or more modified second decoder input sequences by changing one or more elements in the first decoder input sequence, a step of performing decoding on each of the at least one or more modified second decoder input sequences, and a step of determining a final decoding result based on results of the decoding performed on each of the at least one or more modified second decoder input sequences, and wherein at least one or more elements to be changed in the first decoder input sequence may be selected from a limited area determined in consideration of a structure of the channel code.

In embodiments, a decoding method for a channel code in a communication system is provided. The method may include a step of receiving a signal encoded with a channel code that is used, and transmitted, a step of generating a first decoder input sequence (or a vector, an array, and the like) from the signal, a step of performing decoding on the first decoder input sequence, a step of checking a second decoder output sequence generated or updated by the decoding, a step of checking or determining one or more element positions based on the second decoder output sequence, a step of generating at least one or more modified third decoder input sequences by changing at least one or more elements of the first decoder input sequence based on the element positions checked or determined based on the second decoder output sequence, a step of performing decoding on each of the at least one or more modified third decoder input sequences, and a step of determining a final decoding result based on results of the decoding performed on each of the at least one or more modified third decoder input sequences.

In embodiments, a decoding method for a channel code in a communication system is provided. The method may include a step of receiving a signal encoded with a channel code that is used, and transmitted, a step of generating a first decoder input sequence (or a vector, an array, and the like) from the signal, a step of generating at least one or more modified second decoder input sequences by adding one or more elements in the first decoder input sequence, a step of performing decoding on each of the at least one or more modified second decoder input sequences, and a step of determining a final decoding result based on results of the decoding performed on each of the at least one or more modified second decoder input sequences. At least one or more elements to be changed in the first decoder input sequence may be selected from a limited area determined in consideration of a structure of the channel code.

### [Description of the Drawings]

FIG. 1 illustrates an example of a wireless communication system.
FIG. 2 illustrates an example of a configuration of a device performing communication in a wireless communication system.
FIG. 3 illustrates an example of a parity check matrix of a low density parity check (LDPC) code.
FIG. 4 illustrates an example of a binary graph corresponding to a parity check matrix.
FIG. 5 illustrates an example of a series of operations for channel encoding.
FIG. 6 illustrates an example of a series of operations for channel decoding.
FIG. 7 illustrates an example of a procedure of ensemble decoding.
FIG. 8 illustrates a block diagram for ensemble decoding.
FIG. 9 illustrates an example of a search range of a position of a log likelihood ratio (LLR) to be changed in ensemble decoding.
FIG. 10 illustrates an example of a limitation of a position of an LLR to be changed in ensemble decoding.
FIG. 11 illustrates an example of a limitation of a position of an LLR to be changed for ensemble decoding in an intrinsic LLR sequence including a systematic puncturing bit.
FIG. 12 illustrates an example of a limitation of a position of an LLR to be changed for ensemble decoding in an intrinsic LLR sequence not including a systematic puncturing bit.
FIG. 13 illustrates an example of a performance according to a limitation of a position of an LLR to be changed for ensemble decoding.
FIG. 14 illustrates an example of a performance according to a limitation of a position of an LLR to be changed for ensemble decoding.
FIG. 15 illustrates a block diagram for a limitation of a position of an LLR to be changed according to a posteriori LLR sequence.
FIG. 16 illustrates examples of a limitation of a position of an LLR to be changed according to a posteriori LLR sequence.
FIG. 17 illustrates an example of a performance of a limitation of a position of an LLR to be changed according to a posteriori LLR sequence.
FIG. 18 illustrates an example of a performance of a limitation of a position of an LLR to be changed according to a posteriori LLR sequence.
FIG. 19 illustrates an example of a performance of a limitation of a position of an LLR to be changed according to a posteriori LLR sequence.
FIG. 20 illustrates a block diagram for ensemble decoding using signal extension.
FIG. 21 illustrates a block diagram for ensemble decoding using signal extension.
FIG. 22 to FIG. 25 illustrate examples of ensemble decoding using signal extension.
FIG. 26 illustrates an example of a performance of ensemble decoding using signal extension.
FIG. 27 illustrates an example of a wireless communication system.
FIG. 28 illustrates network entities according to a distributed deployment.
FIG. 29 illustrates an example of a function split of network entities.

### [Mode for Invention]

Hereinafter, an embodiment of the present invention will be described in detail with reference to the accompanying drawings.

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a signal (e.g., signal, information, message, signaling), a term referring to a data type (e.g., list, set, subset), a term for an operation state (e.g., step, operation, procedure), a term referring to data (e.g., packet, user stream, information, bit, symbol, codeword), a term referring to a resource (e.g., symbol, slot, subframe, radio frame, subcarrier, resource element (RE), resource block (RB), bandwidth part (BWP), occasion), a term referring to a channel, a term referring to network entities, a term referring to a component of a device, and the like, that are used in the following description, are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In describing embodiments, a description of a technical content that is well known in a technical field to which the present invention belongs and that is not directly related to the present invention is omitted. This is to more clearly convey a gist of the present invention without obscuring the gist of the present invention by omitting an unnecessary description.

For the same reason, in the accompanying drawings, some components are emphasized, omitted, or schematically illustrated. In addition, a size of each component does not entirely reflect an actual size. In each drawing, the same reference numerals are assigned to the same or corresponding components.

An advantage and a feature of the present invention, and a method for achieving the same, will become apparent with reference to embodiments described below in detail in conjunction with the accompanying drawings. However, the present invention is not limited to embodiments disclosed below, but may be implemented in various different forms, and the embodiments are provided only in order to make a disclosure of the present invention complete, and to fully inform a person having ordinary skill in a technical field to which the present invention belongs of a scope of the invention, and the present invention is only defined by a scope of claims. Throughout the specification, the same reference numerals denote the same components.

At this time, it will be understood that each block of flowchart drawings and combinations of the flowchart drawings may be performed by computer program instructions. These computer program instructions may be mounted on a processor of a general-purpose computer, a special-purpose computer, or other programmable data processing equipment, and thus the instructions performed through the processor of the computer or other programmable data processing equipment generate a means for performing functions described in a flowchart block(s). These computer program instructions may also be stored in a computer-usable or computer-readable memory capable of directing a computer or other programmable data processing equipment to implement functions in a specific manner, and thus the instructions stored in the computer-usable or computer-readable memory also make it possible to produce an article of manufacture including an instruction mean for performing functions described in flowchart block(s). The computer program instructions may also be mounted on a computer or other programmable data processing equipment, and thus a series of operation steps are performed on the computer or other programmable data processing equipment to generate a process executed by the computer, and the instructions for performing the computer or other programmable data processing equipment also make it possible to provide steps for executing functions described in a flowchart block(s).

In addition, each block may indicate a module, a segment, or a portion of code including one or more executable instructions for executing a specified logical function(s). In addition, in some alternative implementations, it should be noted that the functions mentioned in the blocks may occur out of order. For example, two blocks illustrated in succession may, in fact, be performed substantially simultaneously, or the blocks may sometimes be performed in a reverse order according to corresponding functions.

At this time, a term "~unit" used in the present embodiment refers to a hardware component such as software or FPGA or ASIC, and "~unit" performs certain roles. However, "~unit" is not limited to software or hardware. "~unit" may be configured to be in an addressable storage medium or may be configured to reproduce one or more processors. Accordingly, as an example, "~unit" includes components such as software components, object-oriented software components, class components, and task components, and processes, functions, properties, procedures, subroutines, segments of program code, drivers, firmware, microcode, circuitry, data, database, data structures, tables, arrays, and variables. A function provided within the components and "~units" may be combined into a smaller number of components and "~units" or may be further separated into additional components and "~units". In addition, the components and "~units" may be implemented to reproduce one or more CPUs within a device or a secure multimedia card.

Hereinafter, various embodiments will be described in detail with reference to the accompanying drawings, and at this time, it should be noted that the same components in the accompanying drawings are denoted by the same reference numerals as much as possible. In addition, it should be noted that the drawings of the present invention attached below are provided to aid understanding of the present invention, and the present invention is not limited to shapes or dispositions illustrated in the drawings of the present invention. In addition, a detailed description of known functions and configurations that may obscure the gist of the present invention will be omitted. In the following description, only portions necessary for understanding operations according to various embodiments of the present invention are described, and it should be noted that descriptions of other portions will be omitted so as not to obscure the gist of the present invention.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

The present disclosure describes various embodiments using terms used in some communication standards (e.g., 3rd Generation Partnership Project (3GPP), European Telecommunications Standards Institute (ETSI), an extensible radio access network (xRAN), or an open-radio access network (O-RAN)), but this is only an example for description. Various embodiments of the present disclosure may be easily modified and applied in another communication system.

The present disclosure relates to a method and a device for decoding data with effective and excellent error-correction performance in a communication and broadcasting system using a turbo code and a low-density parity-check code (LDPC code), which gradually update a posterior probability for codeword bits or a metric corresponding thereto by an iterative decoding operation. The present disclosure relates to a communication technique for converging a 5G communication system for supporting a higher data rate after a 4G system with an IoT technology and a system thereof. The present disclosure may be applied to an intelligent service (for example, a smart home, a smart building, a smart city, a smart car or a connected car, a health care, a digital education, a retail, a security or a safety-related service) based on a 5G communication technology and an IoT-related technology. The present disclosure provides a device and a method for efficiently decoding a bit, a symbol, a signal, and the like, which are encoded with a channel code such as the low-density parity-check (LDPC) code, the turbo code, and the like and transmitted to a channel in the communication or broadcasting system. In addition, the present disclosure provides a device and a method for efficiently realizing and implementing an ensemble decoding for determining a final result by decoding two or more modified LLR sequences generated by changing a value of at least one element in a log-likelihood ratio (LLR) sequence input to a decoder. Specifically, an ensemble decoding method and device according to an embodiment of the present disclosure are characterized in determining at least one element for changing the value based on a limited range in consideration of a structure and a characteristic of a code to be used. In addition, specifically, the ensemble decoding method and device according to the embodiment of the present disclosure are characterized in attempting to decode based on a decoder input LLR sequence, and determining at least one element to change the value based on the decoder output LLR sequence obtained accordingly.

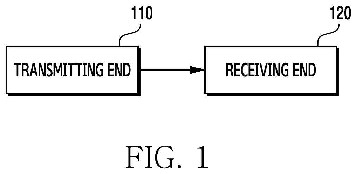

FIG. 1 illustrates an example of a wireless communication system according to various embodiments of the present disclosure. FIG. 1 exemplifies a transmitting end 110 and a receiving end 120 as a portion of devices or nodes using a wireless channel in the wireless communication system. FIG. 1 illustrates one transmitting end 110 and one receiving end 120, but the wireless communication system may include a plurality of transmitting ends or a plurality of receivers. In addition, for convenience of description, in the present disclosure, although the transmitting end 110 and the receiving end 120 are described as separate entities, functions of the transmitting end 110 and the receiving end 120 may be interchanged. For example, in a case of an uplink of a cellular communication system, the transmitting end 110 may be a terminal, and the receiving end 120 may be a base station or a portion (e.g., a digital unit (DU), a distributed unit (DU), a radio unit (RU), a massive multiple input multiple output unit (MMU)) of the base station. In a case of a downlink, the transmitting end 110 may be a base station or a portion (e.g., a digital unit (DU), a distributed unit (DU), an RU, an MMU) of the base station, and the receiving end 120 may be a terminal.

The base station is a network infrastructure providing a wireless access to the terminal. The base station has a coverage defined based on a distance at which a signal may be transmitted. In addition to the base station, the base station may be referred to as an access point (AP), a radio access network (RAN) node, an eNodeB (eNB), a 5th generation node (5G node), a next generation nodeB (gNB), a wireless point, a transmission/reception point (TRP), a communication node, a wireless communication device, a wireless communication equipment, a network node, a network entity, or another term having an equivalent technical meaning.

The terminal is a device used by a user, and performs communication with the base station through a wireless channel. A link from the base station toward the terminal is referred to as a downlink (DL), and a link from the terminal toward the base station is referred to as an uplink (UL). In addition, although not illustrated in FIG. 1, the terminal and another terminal may perform communication with each other through the wireless channel. In this case, a link between the terminal and the another terminal (device-to-device link (D2D)) is referred to as a sidelink, and the sidelink may be used interchangeably with a PC5 interface. In some other embodiments, the terminal may be operated without involvement of the user. According to one embodiment, the terminal is a device that performs machine type communication (MTC), and may not be carried by the user. In addition to the terminal, the terminal may be referred to as a 'user equipment (UE)', a 'customer premises equipment (CPE)', a 'mobile station', a 'subscriber station', a 'remote terminal', a 'wireless terminal', an 'electronic device', or a 'user device', or another term having an equivalent technical meaning.

According to an embodiment, the transmitting end 110 may generate a codeword by encoding information bits based on a turbo code. The receiving end 120 may decode a signal of the received codeword based on the turbo code. For example, the receiving end 120 may use a turbo decoding scheme according to the present invention, and may perform checking with a cyclic redundancy check (CRC) code that is concatenated, in order to determine whether a decoding result is normal. The transmitting end 110 and the receiving end 120 perform encoding and decoding by using a structure (a trellis, a linear feedback shift register, and the like) of the turbo code known to each other. For example, the structure of the turbo code may include a trellis, a linear feedback shift register, and the like defined in a 3GPP LTE standard.

According to an embodiment, the transmitting end 110 generates a codeword by encoding the information bits based on an LDPC code, and the receiving end 120 may decode a signal of the received codeword based on the LDPC code. For example, the receiving end 120 may use an LDPC decoding scheme according to embodiments of the present disclosure. The receiving end 120 may perform a syndrome check in order to determine whether a decoding result is normal. The transmitting end 110 and the receiving end 120 may respectively perform LDPC encoding and decoding by using a parity check matrix known to each other. For example, the parity check matrix may include a parity check matrix defined in a 3GPP NR standard.

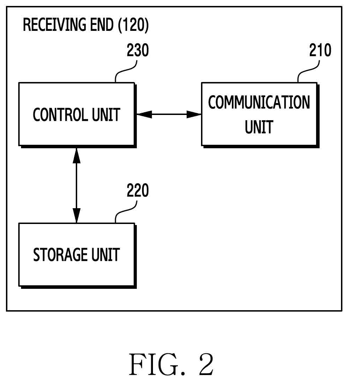

FIG. 2 illustrates an example of a configuration of a device performing communication in a wireless communication system. That is, the configuration illustrated in FIG. 2 may be understood as a configuration of a receiving end 120. Hereinafter, terms such as '...unit' and '...device' refer to a unit that processes at least one function or operation, and may be implemented in hardware, software, or a combination of hardware and software.

Referring to FIG. 2, the device may include a communication unit 210, a storage unit 220, and a control unit 230.

The communication unit 210 may perform functions for transmitting and receiving a signal through a wireless channel. For example, the communication unit 210 may perform a function of converting between a baseband signal and a bit sequence according to a physical layer specification of a system. For example, when transmitting data, the communication unit 210 may generate complex symbols by encoding and modulating a transmit bit sequence. In addition, when receiving data, the communication unit 210 may restore a receive bit sequence through demodulation and decoding of the baseband signal. In addition, the communication unit 210 may up-convert the baseband signal into a radio frequency (RF) band signal and then transmit it through an antenna, and may down-convert the RF band signal received through the antenna into a baseband signal.

To this end, the communication unit 210 may include a transmit filter, a receive filter, an amplifier, a mixer, an oscillator, a digital to analog convertor (DAC), an analog to digital convertor (ADC), and the like. In addition, the communication unit 210 may include a plurality of transmit and receive paths. Furthermore, the communication unit 210 may include at least one antenna array configured with a plurality of antenna elements. In terms of hardware, the communication unit 210 may be configured with a digital unit and an analog unit, and the analog unit may be configured with a plurality of sub-units according to operation power, operation frequency, and the like. In addition, the communication unit 210 may include a decoding unit to perform decoding according to embodiments of the present disclosure.

The communication unit 210 transmits and receives a signal as described above. Accordingly, the communication unit 210 may be referred to as a 'transmission unit', a 'reception unit', or a 'transceiver'. In addition, in the following description, transmission and reception performed through the wireless channel are used to include that the processing as described above is performed by the communication unit 210. In addition, in a case that the device of FIG. 2 is a base station, the communication unit 210 may further include a backhaul communication unit for communication with another network entity connected through a backhaul network. For example, the communication unit 210 may include at least one transceiver configured to transmit or receive signals.

The storage unit 220 may store data such as a basic program, an application program, and setting information for an operation of the receiving end 120. The storage unit 220 may be configured with a volatile memory, a non-volatile memory, or a combination of the volatile memory and the non-volatile memory. In addition, the storage unit 220 may provide stored data according to a request of the control unit 230.

The control unit 230 may control overall operations of the device (e.g., the receiving end 120). For example, the control unit 230 may transmit and receive a signal through the communication unit 210. In addition, the control unit 230 may write data to or read data from the storage unit 220. The control unit 230 may perform functions of a protocol stack required in a communication standard. For this, the control unit 230 may include at least one processor or micro processor, or may be a portion of a processor. According to various embodiments, the control unit 230 may control the device to perform operations according to various embodiments described later.

The configuration of the receiving end 120 illustrated in FIG. 2 is only an example, and an implementation example of the device that performs embodiments of the present disclosure from the configuration illustrated in FIG. 2 is not limited thereto. In some embodiments, a portion of the configuration may be added, deleted, or changed.

In a process of describing the present disclosure in detail, a generally used mathematical symbol is used to avoid ambiguity of a meaning. Such mathematical symbol may be clearly understood by a person having ordinary skill in the art to which the present disclosure pertains. Representatively, in the present disclosure, a following commonly known mathematical symbol is used.
- A calligraphic character (e.g., 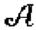 ) is used to refer to a set.
- Unless otherwise stated throughout the present disclosure, it is assumed that an index of a first element of a set, a sequence, and a vector starts from 0 (zero-based numbering).
- For a set 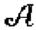 = 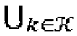 {*aₖ*} of indexed elements, 〈 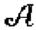 〉 indicates an index set 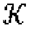 of the elements. For example, for 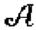 = {*a*₃, *a*₄, *a*₇, *a*₈}, 〈 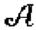 〉 = {3, 4, 7, 8}.
- For two sets 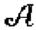 and 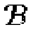 , 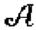 \ 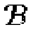 indicates a relative complement of the set 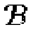 with respect to the set 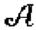 .
- For the set 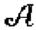 and an arbitrary number *b* , *b* + 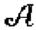 indicates a set {*a + b* | *a* ∈ 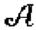 } composed of values obtained by adding *b* to all elements of 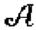 .
- Symbols 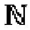 , 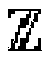 , and 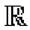 are respectively used to indicate a set of natural numbers, a set of integers, and a set of real numbers.
- ${F}_{2} = \left\{0, 1\right\}$ indicates a binary field.
- For a non-negative integer *n*, ${ℤ}_{n}$ indicates a set of *n*consecutive integers from 0 to *n* - 1. That is, ${ℤ}_{n} = \left\{0,1,…,n-1\right\}$.
- A boldface lowercase character (e.g., **a**) is used to indicate a vector, and a boldface uppercase character (e.g., **A)** is used to indicate a matrix. In a case of the vector, unless otherwise stated, it indicates a column vector.
- For the vector **a** and the matrix **A**, **a***^{T}* and ***A***^{T} respectively indicate a transpose of each.
- For the matrix **A** and two non-negative integers *i* and *j*, (***A***)_{*i*,*j*} indicates an element of an *i*-th row and a *j*-th column of the matrix **A**.
- For the matrix **A** and a set of the two non-negative integers 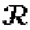 and 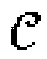 , 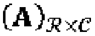 indicates a submatrix composed of rows designated by elements of a set 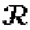 and columns designated by elements of a set 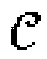 in the matrix **A**.

A turbo code and a low-density parity-check code (LDPC code) are error-correction codes showing a performance close to a channel capacity. Due to an excellent performance and a characteristic suitable for implementation, the turbo code and the LDPC code are used in various communication and broadcasting systems. Representatively, the turbo code is adopted and used in a 4th generation (4G) Long-Term Evolution (LTE) mobile communication system standard of 3GPP, and the LDPC code is adopted and used in a 5th generation (5G) New Radio (NR) mobile communication system standard of the 3GPP.

Hereinafter, embodiments of the present invention are described based on a communication or broadcasting system using the LDPC code. However, this is only an example for avoiding a portion that may be redundantly described for different channel coding schemes and for simplifying description. Various embodiments described may be easily modified and applied also to a communication system and/or a broadcasting system using another channel coding scheme including the turbo code.

First, a characteristic of the LDPC code as channel coding is described. The LDPC code is a linear code. Each LDPC code is generally defined by a parity check matrix. The number of input bits to be encoded using the LDPC code is represented as *K,* and the number of output bits of an encoded result is represented as *N.* In terms of a coding theory, the number of input bits *K* of encoding is referred to as a code dimension, and the number of output bits *N* of encoding is referred to as a code length. A code rate, which is one of important characteristics of a channel code, is defined as *R = K* / *N*, and a value *M* = *N* - *K* obtained by subtracting the code dimension from the code length is referred to as the number of parity bits or the number of redundant bits.

The LDPC code having the code dimension *K* and the code length *N* is defined by a parity check matrix $H ∈ {F}_{2}^{M \times N}$. All valid codeword vectors $x ∈ {F}_{2}^{N}$ generated by the LDPC code defined by the parity check matrix **H** satisfy a relation of Equation 1 below.${Hx}^{T} = 0$

**H** indicates the parity check matrix of the LDPC code, and a vector **x** indicates a codeword. In the Equation 1, $O ∈ {F}_{2}^{M}$ is a zero vector of a length *M*. According to the Equation 1, the codeword vector **x** generated by encoding with the LDPC code defined by the parity check matrix **H** is a nullspace with respect to the parity check matrix **H**. A row vector corresponding to the *j*-th row of **H** is denoted as ${h}_{j} ∈ {F}_{2}^{N}$, and an element of the *j*-th row and the *i*-th column of **H** is written as ${h}_{j} ∈ {F}_{2}^{N}$ . Encoding and decoding of the LDPC code a re performed based on the parity check matrix **H**.

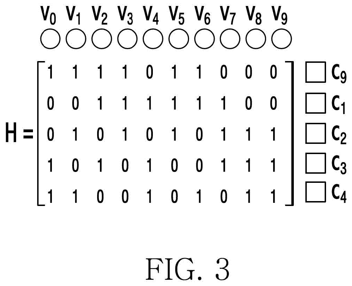

FIG. 3 illustrates an example of a parity check matrix of a low density parity check (LDPC) code. Through FIG. 3, general operations of the LDPC code defined by a parity check matrix **H** are described. Decoding of the LDPC code may be understood as a so-called belief-propagation (BP) process in which messages are repeatedly passed on a bipartite graph corresponding to the parity check matrix **H**.

Referring to FIG. 3, an example of a parity check matrix $H ∈ {F}_{2}^{5 \times 10}$ of a binary LDPC code having the number of rows is *M* = *N* - *K* = 5 and the number of columns is *N* = 10 illustrated. In the parity check matrix, the number of elements of '1' is referred to as a density, and the density may be used to determine computational complexity of encoding and decoding. A density of a general parity check matrix of the LDPC code is very low compared to an overall size *NM* of the parity check matrix. Due to this characteristic, a class of the LDPC code is referred to as a low-density parity check code. However, the parity check matrix of FIG. 3 is only an example for explaining a principle of the LDPC code through very small *N* and *M*, and thus it should be noted that a density is relatively high. An LDPC code generally designed has larger *N* and *M* than the example of FIG. 3, and a density of the parity check matrix may be much lower.

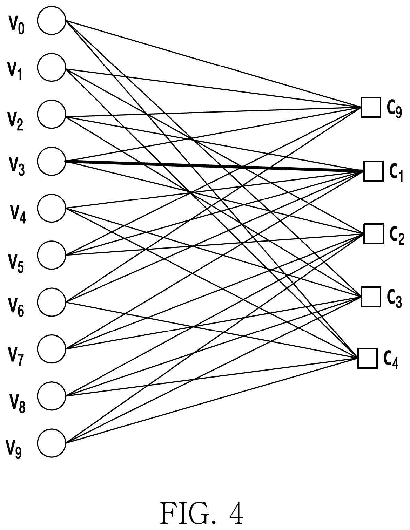

FIG. 4 illustrates an example of a binary graph corresponding to a parity check matrix.

Referring to FIG. 4, a bipartite graph 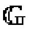 formed when the parity check matrix **H** of FIG. 3 is considered as a biadjacency matrix is illustrated. The bipartite graph 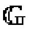 is configured with a variable node set *V* (|*V*| = *N*), *a* check node set 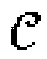 (| 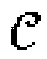 | = *N* - *K*), and an edge set*ε* connecting elements of the two sets. By a conventional representation of a graph theory, (*vᵢ, cⱼ*) ∈ *ε* indicates that an i-th variable node *vᵢ* ∈ *V* and a j-th check node *cⱼ* ∈ 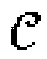 are connected. Conversely, (*vᵢ*, *cⱼ*) ∈ *ε* indicates that the i-th variable node *vᵢ* ∈ *V* and the j-th check node *cⱼ* ∈ 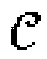 are not connected. For the parity check matrix **H**, when a value of an element *hⱼᵢ* of a j-th row and an i-th column is 1, (*vᵢ, cᵢ*) ∈ *ε* and when the value of *hⱼᵢ* is 0, (*vᵢ, cⱼ*) ∉ *ε.*

Variable nodes (e.g., v0, v1,..., v9) correspond to each bit of a codeword output vector $x ∈ {F}_{2}^{N}$, and the i-th variable node *vᵢ* ∈ *V* corresponds to an i-th codeword bit *xᵢ* having the same index. A check node indicates a linear equation indicated by an inner product on a binary field of each row of the parity check matrix **H** and a codeword vector **x**. Specifically, the j-th check node *cⱼ* ∈ 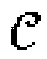 indicates a linear equation corresponding to ${h}_{j} ⋅ x = {\sum }_{i = 0}^{N - 1} {h}_{ji} {x}_{i} = 0$ This linear equation indicates that, when bit values corresponding to all variable nodes connected to the *j*-th check node on the bipartite graph given by **H** are binary-summed (modulo-2 sum or bitwise-XOR), a result is 0. BP decoding of the LDPC code may be understood as an iterative message passing process using a relation between a variable node and a check node on this graph.

The LDPC code is used in various communication systems and broadcasting systems, and is designed and used to satisfy a requirement given according to a characteristic of a system.

For example, one of requirement characteristics of a channel code for a communication system is length-flexibility of a code length. In the communication system, the number of information bits to be transmitted may change at every transmission according to a message to be transmitted. For example, in a case of transmitting multimedia information such as a video, the number of information bits may be large. Conversely, in a case of transmitting a text message, the number of information bits may be small. Additionally, in the communication system, an amount of communication resources such as time and frequency available for transmitting specific information may change at every transmission for various reasons. For example, an amount of total available communication resources may change, or an amount of communication resources allocated for transmitting corresponding information from among the total available communication resources may change. Since the number of bits to be transmitted changes at every transmission time, the channel code used for the communication system should be designed to flexibly process encoding and decoding in a situation in which the number of input bits and the number of output bits of encoding change variably.

Another requirement characteristic of the channel code for the communication system is rate-flexibility of a code rate. In the communication system, particularly in a mobile communication system, a channel quality between a transmitter and a receiver changes from moment to moment. For example, in a case that the receiver physically moves, a distance between the transmitter and the receiver changes, and thus a channel environment such as path loss and multi-path fading may change. In a case that a quality of a channel is good, the transmitter may increase the code rate (i.e., reduce the number of parity bits) to achieve error-free encoding and decoding through efficient utilization of communication resources. Conversely, in a case that the quality of the channel is poor, the transmitter may decrease the code rate (i.e., increase the number of parity bits) to increase a probability of overcoming a poor channel. Therefore, the channel code used for the communication system should be designed to flexibly change the code rate according to a situation.

The LDPC code for the practical communication and broadcasting system is designed to have the requirement characteristic (flexible code length matching, or flexible rate matching). As an example, in a 3GPP NR mobile communication system, an LDPC code satisfying the requirement characteristic is designed and used.

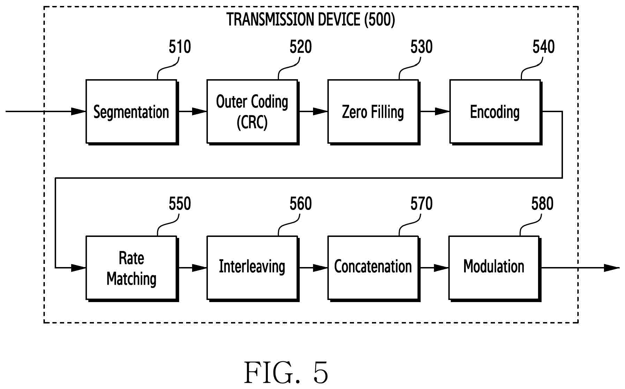

FIG. 5 illustrates an example of a series of operations for channel coding. Hereinafter, a device performing the series of operations of the channel coding is referred to as a transmission device, but a term "transmission device" is only for referring to a device performing signal processing for transmission of a signal, and the term is not interpreted as excluding receiving signals from another device.

Referring to FIG. 5, a transmission device 500 may perform segmentation 510, outer encoding 520, zero filling 530, LDPC encoding 540, rate matching 550, interleaving 560, concatenation 570, and/or modulation 580 in order to transmit an input bit sequence by performing LDPC encoding and modulation. Components illustrated in FIG. 5 are components for performing encoding and modulation on the input bit sequence, which is only an embodiment, and according to a case, a portion of the components illustrated in FIG. 5 may be omitted or changed, and another component may be added.

The transmission device 500 determines code parameters to be used for an LDPC code based on a given scheduling parameter such as the number of input bits, the number of final output bits, and a code rate that is a relation therebetween, in order to perform encoding and modulation. For example, the code parameters may include at least one of a parity check matrix of the LDPC code to be used, information on the parity check matrix, information for segmentation, information (e.g., shortening, puncturing, repetition, and the like) for code rate matching, information for bit interleaving, and/or information for modulation.

Information bits to be transmitted by the transmission device 500 may be referred to as a transport block (TB). Accordingly, the number of bits of the transport block may be referred to as a transport block size (TBS). The transport block may be a result obtained by being encoded by an outer concatenation code such as cyclic redundancy check (CRC) encoding.

In a general communication system, the number of bits to be transmitted, that is, a transport block size (TBS) (or a sum of the TBS and the number of parity bits generated by the outer concatenation code), may be variable according to a situation. In a case that the TBS is greater than the maximum number of input bits that may be encoded by the determined parity check matrix **H**, the transmission device 500 may perform the segmentation 510. The transport block may be divided into two or more code blocks (CBs), that is, may be segmented. Each of segmented code blocks is input to one LDPC encoder. In a case that the number of input bits is less than or equal to a preset value, segmentation may not be performed. Therefore, in FIG. 5, the segmentation unit 510 may be omitted. The number of code blocks determined or calculated by the process may be referred to as *C*. For an index *r* = 0, ... , *C* - 1, a *r*-th code block is indicated as ${a}_{r} ∈ {F}_{2}^{{A}_{r}}$, herein, ***Aᵣ*** indicates a length of a corresponding code block.

The transmission device 500 may perform the outer encoding 520. Each of segmented code blocks may be encoded by a concatenated outer code. As the outer code, there is CRC encoding and the like, and the outer code is not limited to a specific coding scheme. Whether to perform the outer encoding 520 and a type of the outer code may be determined differently according to whether the segmentation has been performed. The outer encoding 520 may be used to improve a performance by assisting a decoding operation of the LDPC code performed in a receiver. The outer encoding 520 may be used to check and verify validity of a decoding result of the LDPC code performed in the receiver. An outer codeword obtained by encoding the *r*-th code block **a***ᵣ* is denoted as a vector ${b}_{r} ∈ {F}_{2}^{{B}_{r}}$, and *Bᵣ* indicates a length thereof (*Bᵣ* ≥ *Aᵣ*). In a case that the outer encoding is not performed, **b**ᵣ = **a***ᵣ*. For consistency, even if the outer encoding is not performed, a result substituted as **b***ᵣ* = **a***ᵣ* is referred to as an outer codeword. A bit sequence generated as described above is input to the LDPC encoder.

Outer codewords for each code block are respectively LDPC encoded independently. Therefore, by identifying how one code block is processed, an overall processing procedure of the transmission device 500 may be understood. Therefore, hereinafter, an LDPC encoding process for one code block is described. For conciseness of expression, by excluding a subscript *r* indicating an index of the code block, the code block is denoted as $a ∈ {F}_{2}^{A}$, and an outer codeword is denoted as $b ∈ {F}_{2}^{B}$, which is a result obtained by outer encoding it.

The outer codeword $b ∈ {F}_{2}^{B}$ of the outer-encoded length *B* is encoded by an LDPC code of a code dimension *K*. The code dimension K indicates the number of bits to be encoded. The LDPC code to be used for encoding may be selected such that the code dimension *K* of the code is as close as possible to the length *B* and is greater than or equal to the length *B.* In a case that the length *B* of the outer codeword is less than the code dimension *K*, the transmission device 500 may perform the zero filling 530. *F* = *K* - *B* filler bits may be added to an encoding input bit sequence. In a case that the length *B* of the outer codeword is equal to the code dimension*K,* the number of filler bits becomes *F* = *K* - *B* = 0. As a non-limiting example, the zero filling 530 may be omitted. The filler bits may be added to the outer codeword **b** in various manners, for example, an appending scheme of adding *F* = *K* - *B* filler bits at the end of **b** may be used. The method of adding the filler bits is not limited to a specific scheme. The filler bits may be determined to have a predetermined fixed value, and generally are determined to have a fixed bit value 0. For this reason, the process of adding the filler bits is also referred to as zero filling, zero padding, zero appending, and the like. Since the filler bits do not have value as actual information, the filler bits may be excluded in a final transmission. The process of excluding the filler bits in the final transmission may be understood as shortening, which is one of code modification methods that reduce a code length and a code dimension by the same size. An encoder input vector $c ∈ {F}_{2}^{K}$ indicates a result obtained by performing the zero filling 530 on the outer codeword **b** to match a length to the code dimension *K* of the LDPC code to be used for encoding. The filler bits are also referred to as shortened bits, and hereinafter, the expression of "shortened bits" is used.

The transmission device 500 may perform the LDPC encoding 540. After matching the input length *K* of the LDPC encoding, the LDPC encoding is performed. The LDPC encoding 540 may be performed based on a parity check matrix $H ∈ {F}_{2}^{M \times N}$ determined by the scheduling parameter, the code parameter, and the like. Specifically, the LDPC encoding 540 is a process of generating a mother codeword vector $x ∈ {F}_{2}^{N}$ of the length *N* satisfying the Equation 1 based on an encoding input vector **c** given through the series of processes. In other words, the LDPC encoding 540 may be understood as a process of obtaining a mother codeword vector **x** satisfying the Equation 1 that is mapped to the encoding input vector **c** based on the parity check matrix **H**. In a case that a bit sequence of the input code block appears as it is in a mother codeword bit sequence, this is referred to as a systematic code, and in a case that not, this is referred to as a nonsystematic code.

As an output of the LDPC encoding 540, the mother codeword vector **x** of the length *N* may be generated. The mother codeword may be modified through the rate matching 550 to be suitable for a transmission environment and transmission resources. A length of a coded bit sequence to be finally transmitted for the code block is referred to as a rate-matching size *E,* and this is a parameter determined by scheduling such as a transmission environment, a transmission resource, and the like. As in the another symbol, a rate-matching size of a *r*-th code block is represented as *E*ᵣ, and herein, since a series of encoding processes for one code block is considered, it should be noted that, for conciseness of expression, a subscript *r* is excluded and is denoted as *E.* The rate matching 550 may be understood as a process of generating a codeword vector $e ∈ {F}_{2}^{E}$ of the length *E* from the mother codeword vector **x** of the length *N.* In order to more clearly distinguish the codeword vector **e** from the mother codeword vector **x**, the codeword vector **e** may also be referred to as a transmitted codeword vector.

The rate matching 550 may be implemented in various manners. For example, the rate matching 550 may be systematically performed through a simple rule by using a circular buffer. A size of the circular buffer to be used is referred to as *N*_{CB}, and *N*_{CB} may be different from the length *N* of the mother codeword. In general, *N*_{cb} may be determined to be less than or equal to *N.* As an example, in a 3GPP NR LDPC encoding system, in a case that there is no specific constraint, *N*_{CB} is determined as *N* - *2Z* (*Z* is a lifting size to be described later and is a positive integer between 2 and 384). When the circular buffer of the length *N*_{CB} is referred to as $d = \left({d}_{0},{d}_{0},…,{d}_{{N}_{cb} - 1}\right) ∈ {F}_{2}^{{N}_{cb}}$, each bit of the circular buffer is determined as a bit of the mother codeword **x** = **(*x*₀, *x*₁, ... , *x*_{*N*-1})** as in Equation 2 below.${d}_{i} = {x}_{2 Z + i} , i = 0 , 1 , … , {N}_{cb} - 1$

In a case of configuring the circular buffer **d** is configured as in the Equation 2, first 2*Z* bits of the mother codeword **x** are not stored and recorded in the circular buffer, and thus, the first 2Z bits of the mother codeword **x** may be excluded from a transmission. A 3GPP NR LDPC code is a systematic code, and in the mother codeword of the length *N*, an encoding input bit sequence (i.e., an information bit sequence) appears as it is in a first *K* bit. Therefore, in the 3GPP NR LDPC encoding system, systematic puncturing or information puncturing, in which 2*Z* bits among information bits are fixedly punctured, occurs. In this way, instead of transmitting fewer information bits, parity bits generated in an encoding process are transmitted more by that amount.

In the rate matching 550, the transmission device 500 sequentially (e.g., a method such as *dₛ, d*_{*s+*1}*, d_{s+2,}* ... ) reads the circular buffer **d** configured as described above from a predetermined starting point *s*, and circularly (e.g., when reaching *d*_{*N*_{cb-1}}*,* which is an end of the buffer, moving to *d*₀, which is a first point of the buffer) reads to select *E* bits. The starting point *S* from which the circular buffer starts to be read may be determined in consideration of using a Hybrid Automatic Repeat reQuest (HARQ). In addition, when selecting *E* bits from the circular buffer, *F* shortened bits added in the zero filling 530 are not selected. If *E* < *N*_{cb} - *F,* puncturing in which (*N*_{cb} - *F*) - *E* bits among codeword bits excluding the shortened bits recorded in the circular buffer are excluded from the transmission may occur. If *E* >*N_{cb}* - *F,* a repetition in which all or a portion of the codeword bits recorded in the circular buffer are transmitted two or more times may occur.

The bit sequence of the length *E* generated by the rate matching may be transmitted through a bit interleaved coded modulation (BICM) scheme, and in this case, in order to appropriately map bits to a modulation symbol, the transmission device 500 may perform the interleaving 560. An interleaving for the rate-matched bit sequence may be performed.

Through the segmentation 510, in a case that the transport block is segmented into two or more code blocks, the transmission device 500 may perform the concatenation 570. Outputs of the series of encoding processes for each code block may be combined into one. Herein, each result of the code block may be simply concatenated sequentially, or results of the code blocks may be concatenated while being interleaved according to a predetermined pattern.

The transmission device 500 may perform the modulation 580 after performing operations in a unit of bit (e.g., the segmentation 510, the outer encoding 520, the zero filling 530, the LDPC encoding 540, the rate matching 550, the interleaving 560, the concatenation 570). Through the modulation 580, signals of a baseband to be transmitted (hereinafter, baseband signals) may be generated. A modulation scheme of the modulation 580 may use, for example, binary phase shift keying (BPSK), ***π*/2** -BPSK, quadrature phase shift keying (QPSK), 16-quadrature amplitude modulation (QAM), 64-QAM, 256-QAM, or 1024QAM scheme, and any other modulation scheme may be applied for transmission of a signal. As a non-limiting example, before and after the modulation 580, or within the modulation 580, various additional operations for allowing a reception device to be described later to effectively demodulate and recover a signal may be performed. The baseband signals may be transmitted by being carried on a carrier of a band to be used for transmission. Through the series of operations, bits of the transport block are transmitted through encoding and modulation.

In FIG. 5, functional configurations for LDPC encoding (e.g., the LDPC encoding 540) have been described, however, according to a case, the transmission device 500 may further include configurations for controlling an operation of the transmission device.

According to an embodiment, the transmission device 500 may further include a communication unit. The communication unit performs functions for transmitting and receiving a signal through a wireless channel. For example, the communication unit performs a conversion function between a baseband signal and a bit according to a physical layer specification of a system. For example, when transmitting data, the communication unit generates a complex symbol by encoding and modulating a transmission bit sequence. In addition, when receiving data, the communication unit restores a reception bit sequence through demodulation and decoding of the baseband signal, additionally, the communication unit transmits by upconverting the baseband signal into a radio frequency (RF) band signal and transmitting it through an antenna, and downconverts the RF band signal received through the antenna into a baseband signal. According to various embodiments, the transmission device 500 may transmit an LDPC-encoded signal to a reception device 600 to be described later.

For this, the communication unit may include a transmission filter, a reception filter, an amplifier, a mixer, an oscillator, a digital-to-analog converter (DAC), and an analog-to-digital converter (ADC). In addition, the communication unit may include a plurality of transmission and reception paths. Furthermore, the communication unit may include at least one antenna array configured with a plurality of antenna elements. In terms of hardware, the communication unit may be configured with a digital unit and an analog unit, and the analog unit may be configured with a plurality of sub-units according to operation power, operation frequency, and the like.

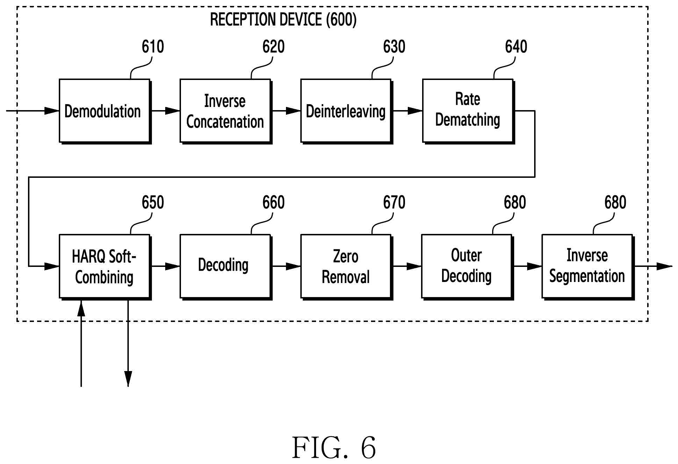

FIG. 6 illustrates an example of a series of operations for channel decoding. Hereinafter, a device performing the series of operations of the channel decoding is referred to as a reception device, however, a term "reception device" is only for referring to a device performing signal processing for transmission of a signal, and the term is not interpreted as excluding transmitting signals to another device.

Referring to FIG. 6, a reception device 600, in order to estimate an accurate information bit from a received signal, may perform demodulation 610, inverse concatenation 620, deinterleaving 630, rate dematching 640, HARQ soft-combining 650, LDPC decoding 660, zero removal 670, outer decoding 680, and/or inverse segmentation 690.

The reception device 600, like the transmission device 500, checks or determines various parameters required for a reception operation based on scheduling information, code parameters, and the like. A series of processes performed by a receiver described below is performed based on various parameters checked and determined as described above.

The reception device 600 may perform the demodulation 610. The demodulation 610 may include various processes according to a case. For example, the demodulation 610 may be subdivided into a process of obtaining a channel estimation result based on the received signal and a soft demapping process of determining values (e.g., a log-likelihood ratio (LLR) or indicators having equivalent technical meanings) required for forward error control (FEC) decoding corresponding to codeword bits transmitted from the demodulated signal or a symbol based on the channel estimation result. In this case, each operation within the demodulation may be subdivided into each channel estimation block, a soft demapping block, and the like. Of course, more various subdivisions are possible according to a structure of a system.

Hereinafter, operations are described assuming the reception device 600 that calculates and processes an LLR value for a codeword bit. However, a metric value used by the reception device to process a signal is not limited to the LLR, and any value equivalent thereto may be used.

In a case that the signal transmitted from the transmission device 500 is configured with two or more code blocks, the inverse concatenation 620, which is an inverse process of the concatenation 570 performed in the transmission device 500, may be performed. The reception device 600 may perform the inverse concatenation 620. The reception device 600 may distinguish an LLR for each code block. If the number of code blocks is one, the inverse concatenation 620 may not be performed. The reception device 600 obtains an LLR sequence for each code block through this process, and a length of an LLR sequence for a *r*-th code block becomes a rate matching size *Eᵣ*. As in the description of the transmission device 500, hereinafter, a series of decoding processes performed by the reception device 600 for one code block is described, and for conciseness of expression, the rate matching size is represented as *E* by excluding a subscript *r*.

If the interleaving 560 is performed in the transmission device 500, the reception device 600 may perform the deinterleaving 630, which is an inverse process thereof. The deinterleaving 630 is a process of changing an order of an LLR sequence of a code block according to a predetermined pattern, and the sequence length *E* does not change. An LLR sequence obtained by performing the inverse concatenation 620 and/or the deinterleaving 630 as described above is represented as Ψ = (*Ψ*₀, *Ψ*₁, ... , Ψ_{*E*-1}).

The reception device 600 may perform the rate dematching 640. The reception device 600 may obtain an LLR sequence or a value equivalent thereto for a codeword that an LDPC decoder is able to process by performing rate dematching, which is an inverse process of the rate matching 550. That is, the reception device 600 may generate an LLR sequence Λ = (*λ*₀ ,*λ*₁, ... *λ*_{*N*_{cb-1}}) for a mother codeword based on the LLR sequence Ψ = (*Ψ*₀, *Ψ*₁, ... , *Ψ*_{*E*-1}) given by the previous process through the rate dematching 640. An *i*-th LLR *λᵢ* is for a mother codeword bit *xᵢ*.

As an example, in a case that rate matching using a circular buffer is performed in a 3GPP NR LDPC encoding system, the reception device 600 may perform the rate dematching 640 through a following process to generate the LLR sequence for the mother codeword.
1) All values of the LLR sequence Λ = (*λ*₀, *λ*₁, ... , *λ*_{*N*_{cb-1}}) for the mother codeword are initialized to 0.
2) A position index for a rate dematching LLR sequence Λ is set to *i* = *s*. A buffer starting position *s* is a value that the transmission device 500 and the reception device 600 are able to mutually check through a series of processes with a scheduling parameter. In addition, a position index for an input LLR sequence Ψ is set to *j* = 0.
3) According to processing of the mother codeword bit determined by the encoding process performed in the transmission device 500, a value of *λᵢ* is determined by performing one of following operations.
   **■** If *xᵢ* is shortened (e.g., a shortened bit having a value 0) in the transmission device *500, λᵢ* is determined as an LLR value indicating that a probability of a bit value 0 is maximum, or a value equivalent thereto. And it is incremented as *i* = *i* + 1, and *j* is left as it is.
   **■** If *xᵢ* is not the shortened bit, it is determined as *λᵢ* = *λᵢ* + *ψⱼ*. That is, *ψⱼ* is accumulated to an existing value of *λᵢ*. If a decoder of the reception device 600 performs a fixed-point operation, a saturation operation or a clipping operation for preventing an overflow may be performed. And each index is incremented as *i* = *i* + 1, and *j* = *j* + 1.
   4) If an index *i* for the rate dematching LLR sequence Λ becomes *N*_{cb} (i.e., reaches the end), it is set to *i* = 0. And the process of 3) is repeatedly performed. This repetition operation is performed until all LLRs of the input LLR sequence ψ are reflected in the rate dematching LLR sequence Λ, that is, until *j* becomes *E.*

Through the rate dematching 640, the reception device 600 obtains the LLR sequence Λ = (*λ*₀, *λ*₁, ... , *λ*_{*N* -1}) for the circular buffer. As a result of the series of processes, an LLR at a shortened bit position is determined as an LLR value indicating that a probability of a bit value 0 is maximum, or a value equivalent thereto. Since no value is accumulated in an LLR at a punctured bit position, an initial value remains as 0, which indicates that probabilities of a bit 0 and a bit 1 are equal to 0.5 and are not biased toward either one.

According to an embodiment, the reception device 600 may generate a rate dematching LLR sequence Λ = (*λ*₀, *λ*₁, ... , *λ*_{*N*-1}) of a length *N* including ^{2Z} systematic-punctured LLRs. In this case, the rate dematching 640 may be modified and performed as follows.
1) All values of the LLR sequence **Λ** = (*λ*₀, *λ*₁, ... , *λ*_{N -1}) for the mother codeword are initialized to 0.
2) A position index for the rate dematching LLR sequence Λ is set to *i* = *s* + 2*Z*. A buffer starting position *s* is a value that the transmission device and the reception device are able to mutually check through a series of processes with a scheduling parameter. In addition, a position index for the input LLR sequence ψ is set to *j* = 0.
3) According to processing of the mother codeword bit determined by the encoding process performed in the transmission device 500, a value of *λᵢ* is determined by performing one of following operations.
   **■** If *xᵢ* is shortened (e.g., a shortened bit having a value 0) in the transmission device *500, λᵢ* is determined as an LLR value indicating that a probability of a bit value 0 is maximum, or a value equivalent thereto. And it is incremented as *i* = *i* + 1, and *j* is left as it is.
   **■** If *xᵢ* is not the shortened bit, it is determined as *λᵢ* = *λᵢ* + *ψⱼ*. That is, *ψⱼ* is accumulated to an existing value of *λᵢ.* If the reception device 600 performs a fixed-point operation, a saturation operation or a clipping operation for preventing an overflow may be performed. And each index is incremented as *i = i* + 1, and = *j* + 1.
4) If an index *i* for the rate dematching LLR sequence Λ becomes *N* (i.e., reaches the end), it is set to *i* = 2*Z*. And the process of 3) is repeatedly performed. This repetition operation is performed until all LLRs of the input LLR sequence Ψ are reflected in the rate dematching LLR sequence Λ, that is, until *j* becomes *E*.

Hereinafter, subsequent operations are described assuming that a rate dematching LLR sequence is generated so as not to include an LLR for a systematic puncturing bit. That is, it is assumed that the rate dematching LLR sequence is obtained as **Λ = (*λ*₀, λ₁, ... , *λ*_{*N*_{cb-1}})**. If the systematic puncturing bit is considered, prepending of 2*Z* LLRs having a value 0 in front of Λ of the length *N*_{cb} may be considered. Therefore, selecting one assumption for conciseness of the description does not make a difference in a final decoding result.

In a mobile communication system, a HARQ operation may be performed in order to guarantee integrity of data and to efficiently utilize entire communication transmission resources. In this case, the reception device operates a HARQ LLR sequence **Λ^{HARQ}** = **(***λ***₀, *λ*₁, ... ,** *λ***_{*N*_{cb-1}})** for each code block by using a separate memory and the like.

The reception device 600 may perform the HARQ soft-combining 650. The reception device 600 may perform soft-combining for HARQ as follows based on **Λ = (*λ*₀, *λ*₁, ... , *λ*_{*N*_{cb-1}})** and ${Λ}^{HARQ} = \left({λ}_{0}^{HARQ},{λ}_{1}^{HARQ},…,{λ}_{{N}_{cb} - 1}^{HARQ}\right)$.
- If this transmission is an initial transmission (a first transmission), **Λ_{HARQ}** is determined as Λ. That is, for all *i* = 0, 1, ... , *N*_{cb} - 1, assignment to ${λ}_{i}^{HARQ} ← {λ}_{i}$ is performed. An element of the rate dematching LLR sequence Λ is not separately updated.
- If this transmission is a retransmission (e.g., a second transmission or a transmission thereafter), elements at each position of Λ_{HARQ} and Λ are added to each other. That is, elementwise addition of two vectors is performed. Specifically, for all *i* = 0, 1, ... , *N*_{cb} - 1, Λ is updated in a manner of ${λ}_{i} ← {λ}_{i} + {λ}_{i}^{HARQ}$. Λ^{HARQ} may be updated in consideration of various forms of memory operation, and typically Λ^{HARQ} is updated as Λ (i.e., for all *i* = 0, 1, ... , *N*_{cb} - 1, assignment to ${λ}_{i}^{HARQ} ← {λ}_{i}$) and may be written again to a corresponding memory.

If there is no HARQ operation of the reception device 600, the HARQ soft-combining 670 may be omitted.

The reception device 600 may perform the LDPC decoding 660. The reception device 600 may perform decoding by receiving the LLR sequence Λ = (*λ*₀, *λ*₁, ... , *λ*_{*N*_{cb-1}}) generated through the series of processes, as an input. As described above, the input LLR sequence may be a sequence including LLRs for 2*Z* systematic puncturing bits. At this time, based on code parameters (e.g., a code dimension *K,* a code length *N,* a rate matching size *E*, a code rate *K*/*E,* and various parameters calculated based thereon and a size of a parity check matrix), the reception device 600 may perform decoding by modifying the input LLR sequence Λ or by using only a portion of Λ. Specifically, in a case that puncturing occurs in the mother codeword due to a high transmission code rate, the reception device 600 may reduce decoding complexity and processing time by not using a portion of a parity check matrix corresponding to bits punctured according to a condition, for decoding.

Decoding for an LDPC code is a process of performing belief-propagation (BP) based on an LLR for a codeword bit. In a BP decoding process, a message passing operation for iteratively updating a posteriori LLR (AP-LLR) for the codeword bits is performed, and a maximum number of this iterative decoding is determined based on a requirement for a decoding performance, time, and the like. Typically, a syndrome check is performed every time the iterative decoding process is performed once or a specific number of times. This is a process of checking whether an estimated bit sequence **x̂** obtained by performing a hard decision based on the updated AP-LLR is a null space of the parity check matrix, that is, whether **Hx̂***^{T}* = **o** is satisfied based on the Equation 1, which is a condition of the LDPC code. In the syndrome check, only a portion of the estimated bit sequence **x̂** may be considered, and in this case, it should be noted that the syndrome check equation may also be modified. The reception device 600 checks validity of the decoded estimated bit sequence **x̂** through the syndrome check, and determines whether to perform early termination of decoding based thereon.

As described above, in a case that a bit of the mother codeword is punctured, in order to reduce the decoding complexity and the processing time, the reception device 600 may perform decoding by using a sub parity-check matrix (sub-PCM) **H'** configured with a submatrix of the parity check matrix **H**. In this case, the above-described series of BP decoding processes may be modified to correspond to the sub parity check matrix **H'**. The decoding operation using the modified parity check matrix **H'** is not essential, but may be typically used to reduce the complexity.

The estimated bit sequence for the code block obtained after the LDPC decoding may include shortened bits having no fixed information amount due to the zero filling 530 performed in the transmission device 500. Accordingly, the reception device 600 may perform the zero removal 670 of excluding the shortened bits from the estimated bit sequence, as an inverse process of the zero filling 530 performed in the transmission device 500.

The reception device 600 may perform the outer decoding 680. In a case that the outer encoding 520 for the code block is performed, a bit sequence obtained as a result of the LDPC decoding may be decoded based on the outer encoding. As a non-limiting example, in a case that an error detection code such as a CRC code is concatenated, the reception device 600 may additionally check validity of whether the bit sequence obtained by LDPC decoding is correct.

If a transport block is configured a plurality of code blocks, the inverse segmentation 690 for deriving a final result by concatenating results of each code block may be performed. This process may be understood as an inverse process of the segmentation 510 performed in the transmission device 500.

A component illustrated in FIG. 6 is a component performing a function corresponding to the component illustrated in FIG. 6, and this is only an embodiment, and according to a case, a portion may be omitted or changed, and another component may be further added, if necessary.

Embodiments of the present disclosure are related to the LDPC decoding 660 among the series of processes performed by the reception device 600. As described above, the LDPC decoding 660 is performed based on the given LLR sequence Λ. An initial LLR sequence provided to the LDPC decoding 660 may be referred to as an intrinsic LLR. This term is for distinguishing from the posteriori LLR (AP-LLR) updated by the iterative belief-propagation in the decoding process.

An LLR indicates an estimation for a value of a corresponding codeword bit and confidence or reliability for the estimation. Specifically, in an embodiment, the LLR *λᵢ* for the codeword bit *xᵢ* may be defined based on a corresponding symbol *yᵢ* observed in the reception device 600. For example, the LLR *λᵢ* may be defined as Equation 3.${λ}_{i} = log \frac{p \left({y}_{i}\left|{x}_{i}=0\right.\right)}{p \left({y}_{i}\left|{x}_{i}=1\right.\right)}$

*λᵢ* indicates an LLR for the codeword bit *xᵢ*. According to a definition of the Equation 3, the LLR is a value obtained by taking a log of a ratio of a likelihood of the observed symbol *yᵢ* for the value of the codeword bit *xᵢ*.

In the Equation 3, if a likelihood for a value 0 of the codeword bit *xᵢ* is greater than a likelihood for a value 1 of the codeword bit *xᵢ*, the LLR *λᵢ* has a positive value greater than 0. Conversely, in the Equation 3, if a likelihood for the value 1 of the codeword bit *xᵢ* is greater than the likelihood for the value 0 of the codeword bit *xᵢ*, the LLR *λᵢ* has a negative value less than 0. Therefore, a sign of the LLR indicates a more likely one among values that a corresponding codeword bit may have.

In another embodiment, an LLR may be defined differently. For example, a numerator and a denominator in a fractional value taking the log of the Equation 3 may be interchanged with each other. This LLR in only changing a sign of the LLR defined as in the Equation 3 (i.e., changing + to -, and - to +). In the present disclosure, an operation of the invention is described by considering the LLR defined as in the Equation 3, but even in a case that the LLR is defined differently, in a case that the sign is changed, it may be applied without any difference.

In the Equation 3, if a difference between the likelihood for the value 0 of the codeword bit *xᵢ* and the likelihood for the value 1 of the codeword bit *xᵢ* is large, an absolute value |*λᵢ*| of the LLR *λᵢ* becomes very large. As an extreme example, if a difference is large as the likelihood for the value 0 of *xᵢ* is 1. and the likelihood for the value 1. of the codeword bit *xᵢ* is 0, the LLR *λᵢ* has a positive infinite value. As an opposite extreme example, if a difference is large as the likelihood for the value 0 of *xᵢ* is 0 and the likelihood for the value 1. of the codeword bit *xᵢ* is 1, the LLR *λᵢ* has a negative infinite value. However, if there is no difference as the likelihood for the value 0 of *xᵢ* and the likelihood for the value 1. of the codeword bit *xᵢ* are identical as 0.5, the LLR *λᵢ* has a value of 0. Therefore, the absolute value of the LLR may be interpreted as indicating confidence or reliability for the estimation for a value that the codeword bit may have.

In the reception device 600, a process of setting an LLR value for the shortened codeword bit and the punctured codeword bit through the rate dematching 640 is based on reliability represented as an absolute value of the LLR. The reception device 600 does not receive a shortened bit but may clearly know that a value thereof is 0. Accordingly, an LLR value for the shortened bit may be set to a positive value equal to or greater than a predetermined value (e.g., a positive infinite value) in order to indicate that a bit value is 0 and confidence or reliability therefor is high. In an actual implementation, the LLR value may be set to an arbitrary positive value that a data type used in the reception device 600 is able to represent. On the other hand, since the reception device 600 is not able to know any information on a punctured bit, an LLR value for a shortened bit is determined as 0. An LLR value of 0 has a meaning that probabilities of two values that a codeword bit may have are identical as 0.5.

An absolute value of each element of the intrinsic LLR sequence Λ may be interpreted as a metric indicating how much an observation result of the reception device 600 for each codeword bit is corrupted by noise. For example, if the absolute value |*λᵢ*| of the LLR *λᵢ* for a codeword bit *xᵢ* is large, the corresponding codeword bit indicates that it is not corrupted in a series of end-to-end transmission processes (e.g., a series of processes in the transmission device 500 and the reception device 600). On the other hand, if the absolute value |*λᵢ*| of the LLR *λᵢ* for the codeword bit *xᵢ* is small to be close to 0, the corresponding codeword bit indicates that it is corrupted in the series of end-to-end transmission processes (e.g., the series of processes in the transmission device 500 and the reception device 600).

The LDPC decoding 660 may be performed through the iterative belief-propagation based on the intrinsic LLR sequence as described above. Hereinafter, an example of belief-propagation decoding of an LDPC code is described. A structure and an architecture of a decoder, an algorithm used, and the like may be configured in various manners, and the following does not limit an application scope of embodiments of the present invention to one specific implementation method. Embodiments of the present disclosure may be applied to various decoding architectures and algorithms, and such an application method may be clearly understood by those skilled in the art to which the present disclosure pertains.

The decoder for the LDPC decoding 660 may receive the intrinsic LLR sequence Λ as an input, and may update an AP-LLR sequence Γ = (*γ*₀, *γ*₁, ... , *γ*_{*N*-1}) through the belief-propagation process based thereon. Regardless of whether the intrinsic LLR sequence Λ includes LLRs for 2*Z* systematic punctured bits, it should be noted that the AP-LLR sequence Γ = (*γ*₀*, γ*₁, ... , *γ*_{*N*-1}) includes the LLRs for 2*Z* systematic punctured bits. An initial AP-LLR sequence Γ during the decoding is set to the intrinsic LLR sequence Λ. In an embodiment, if the intrinsic LLR sequence Λ does not include the LLRs for systematic punctured bits (i.e., Λ = (*λ*₀, *λ*₁, ... , *λ*_{*N*_{cb-1}}) ), the initial AP-LLR Γ = (*γ*₀, *γ*₁, ... , *γ*_{*N*-1}) may be set as Equation 4 below.${γ}_{i} ← \left\{\begin{matrix}0 , & if i < 2 Z \\ {λ}_{i - 2 Z} , & if i \geq 2 Z\end{matrix}\right. for i = 0 , 1 , … , N - 1$

In an embodiment, if the intrinsic LLR sequence Λ includes the LLRs for the systematic punctured bits (i.e., Λ = (*λ*₀, *λ*₁, ... , *λ*_{*N*-1})), the initial AP-LLR ccc may be set as Equation 5 below.${γ}_{i} ← {λ}_{i} for i = 0 , 1 , … , N - 1$

As described above, if the LDPC decoder uses the sub parity-check matrix (sub-PCM) **H'** by considering the punctured bit, it should be noted that a code length actually considered above may be smaller than a code length ***N*** of a mother code. Since whether the sub parity-check matrix is used is not related to a detailed operation of the decoder, a decoding operation is described below assuming that the parity check matrix **H** is used.

The AP-LLR sequence set as described above is updated for each iteration by the iterative belief-propagation operation of the LDPC decoding. This process may be understood as a message passing operation between a variable node (VN) and a check node (CN) on a bipartite graph corresponding to the parity check matrix (or the sub parity-check matrix).

First, a message transmitted from the VN to the CN is determined based on the intrinsic LLR sequence or the AP-LLR sequence determined based thereon. The message from the VN to the CN (a variable-to-check message, hereinafter, a V2C message) that the VN *vᵢ* transmits to a neighboring *cⱼ* is represented as *α*_{*i*→*j*}. For example, in an early stage of the decoding operation, the V2C message is determined as Equation 6 below.${α}_{i \to j} ← {γ}_{i} , ∀ j ∈ \left〈{C}_{i}\right〉$

In the Equation 6, 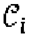 is a set of all neighboring CNs of the VN *vᵢ*, and 〈 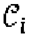 〉 indicates a set of indices of CNs belonging to 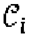 .

In each CN, the decoder calculates a message to be transmitted again to the neighboring VN based on the V2C message received from the neighboring VN. The message from the CN to the VN (check-to-variable message, hereinafter, C2V message) that the CN *cⱼ* transmits to the neighboring VN *vᵢ* is represented as *β*_{*j*→*i*}. For example, the C2V message may be calculated as Equation 7 below.${β}_{j \to i} ← 2 {tanh}^{- 1} \left({\prod }_{k ∈ \left〈{V}_{j}\right〉 \ \left\{i\right\}} tanh \left(\frac{{α}_{k \to j}}{2}\right)\right)$

In the Equation 7, 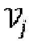 is a set of all neighboring VNs of the CN *cⱼ*, and 〈 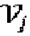 〉 indicates a set of indices of VNs belonging to 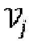 . As in the Equation 7, the C2V message *β*_{*j*→*i*} that the CN *cⱼ* transmits to the neighboring VN *vᵢ* is calculated based on the V2C message received from all other neighboring VN except the VN *vᵢ*.

A calculation of the C2V message according to the Equation 7 may be calculated by being approximated and modified in various manners. In an embodiment, the C2V message calculation as in the Equation 7 may be calculated as Equation 8 below by using a so-called minsum approximation method. ${β}_{j \to i} ← A \times \left({\prod }_{k ∈ \left〈{V}_{j}\right〉 \ \left\{i\right\}} sgn \left({α}_{k \to j}\right)\right) \times max \left({min}_{k ∈ \left〈{V}_{j}\right〉 \ \left\{i\right\}}\left|{α}_{k \to j}\right|-B,0\right)$

In the Equation 8, sgn(·) is a function outputting a sign ±1 of an input value. And in the Equation 8, *A* is a normalization value greater than 0, and *B* is an offset value equal to or greater than 0. The calculation of the C2V message according to the Equation 8 is widely used because an operation is simple, implementation is easy, and a result is well approximated, compared to the calculation of the C2V message according to the Equation 7.

When calculating the C2V message for VNs where the CNs are neighboring, each VN updates the AP-LLR and the V2C message based on the intrinsic LLR and the C2V message received from the neighboring CN. First, the AP-LLR *γᵢ* of the VN *vᵢ* may be calculated as Equation 9 below. ${γ}_{i} ← {λ}_{i} + {\sum }_{j ∈ \left〈{C}_{i}\right〉} {β}_{j \to i}$

And the V2C message in which the VN *vᵢ* transmits to the neighboring CN *cⱼ* may be calculated as Equation 10 below. ${α}_{i \to j} ← {λ}_{i} + {\sum }_{k ∈ \left〈{C}_{i}\right〉 \ \left\{j\right\}} {β}_{k \to i}$

The V2C message calculated as in the Equation 10 may also be simply calculated as in Equation 11 below by using the AP-LLR *γᵢ* calculated in the Equation 9.${α}_{i \to j} ← {γ}_{i} - {β}_{j \to i}$

An estimation for each codeword bit may be performed based on the AP-LLR updated as in the Equation 9. An estimation *x̂ᵢ* for the codeword bit *xᵢ* based on the updated AP-LLR *γᵢ* may be obtained through a hard decision process as in Equation 12 below.${\hat{x}}_{i} ← \left\{\begin{matrix}0 , & if {γ}_{i} > 0 \\ 1 , & if {γ}_{i} < 0\end{matrix}\right.$

A hard decision as in the Equation 12 is according to a definition of the LLR of the Equation 3. If the definition of the LLR is different, the hard decision of the Equation 12 may be modified accordingly. In a case that the decoder of the LDPC code is implemented by a fixed-point representation scheme, the AP-LLR *γᵢ* may be exactly 0. In this case, in the hard decision process of the Equation 12, the estimation *x̂ᵢ* may be determined according to a pre-determined rule. In an embodiment, in a case that the AP-LLR *γᵢ* is 0, the estimation *x̂ᵢ* may be determined by fixing to one of a value 0 or a value 1. In an embodiment, in a case that the AP-LLR *γᵢ* is 0, the estimation ***x̂****ᵢ* may be determined by randomly selecting one of the value 0 or the value 1.

When an estimation for all codeword bits is obtained as described above, it is checked whether an estimated codeword vector **x̂ = (*x̂*₀, *x̂*₁, ... , *x̂*_{*N*-1})** is valid in terms of the given LDPC code, that is, whether **Hx*^{T}* = o** is satisfied (e.g., the [Equation 1]). This process is referred to as a syndrome check. If the estimated codeword vector **x̂** satisfies the syndrome check equation **Hx̂*^{T} =* o,** since the estimated codeword vector is valid in terms of the LDPC code used by the estimated codeword vector, the decoder may output **x̂** as a result and may early terminate the LDPC decoding 660 even if decoding up to a preset maximum number of iterations is not performed. If the estimated codeword vector **x̂** does not satisfy the syndrome check equation **Hx̂*^{T}* = o,** a series of processes including the C2V message calculation, the P-LLR update, the V2C message calculation, and the hard decision may be repeated within the preset maximum number of iterations. If the estimated codeword vector **x̂** satisfying the syndrome check equation **Hx̂*^{T}* = o** is not found within the preset maximum number of iterations, the decoder may determine that decoding has failed and may terminate a decoding series of processes.

The syndrome check equation **Hx̂*^{T}* = o** performs a syndrome check for all elements of the estimated codeword vector. However, since what is of interest in terms of of the reception device 600 is information bits included in the estimated codeword vector, the reception device 600 may determine validity of a decoding result by using only a portion of the syndrome check equation without using all estimated codeword vectors.

As in the above-described series of message passing processes, the initially given intrinsic LLR value is passed to neighboring nodes according to the structure of the bipartite graph, and is used to update the AP-LLR. If an absolute value of the intrinsic LLR value is small, such a value does not significantly affect the belief-propagation decoding operation. In other words, an LLR value having low reliability generated by an observation result interfered with or corrupted by a channel does not affect decoding. Based on a characteristic of this the belief-propagation process, the decoder of the LDPC code may improve a performance by processing the LLR having low reliability (i.e., an LLR having a small absolute value) in a specific manner. Specifically, the decoder of the LDPC code may test all guesses for bits determined to have low reliability and may select one of them. For example, the decoder of the LDPC code may identify positions of *p* bits determined to have low reliability. Reliability of a bit may be determined or evaluated according to various criteria, and may be determined or evaluated based on an absolute value of an LLR generated by receiving a signal from the channel. And the decoder may generate 2*^{p}* possible bit patterns for the *p* bits determined or identified to have low reliability, reflect the bit patterns in the LLR, decode each of them, and then combine results thereof to determine a final result. For example, if *p* = 3, all possible bit patterns are given 2*^{p}* = 8 as **{000, 001, 010, 011, 100, 101, 110, 111},** and one of them corresponds to correct bits transmitted by a transmitter. A method of reflecting each bit pattern in the LLR is to substitute an LLR having a maximum absolute value corresponding to a bit value at a position of each bit. Based on the Equation 3, the LLR having the maximum absolute value for a bit 0 may be +∞, and in an actual implementation, may be an arbitrary positive value in consideration of a representable LLR range and to avoid occurrence of various numerical problems. Based on the Equation 3, the LLR having the maximum absolute value for the bit 1 may be -∞, and in the actual implementation, may be an arbitrary negative value in consideration of the representable LLR range and to avoid occurrence of various numerical problems. 2*^{p}* = 8 modified candidate LLR sequences generated as described above are decoded respectively. A decoding operation performing iterative message passing as in belief-propagation decoding causes an LLR of each bit to affect updating of an AP-LLR of another bit. Accordingly, among the 2*^{p}* modified candidate LLR sequences, a sequence including the correct bit transmitted by the transmitter increases a probability of decoding success by positively affecting improvement of other bits through the iterative belief-propagation decoding. Whether decoding succeeds may be determined by an LDPC code and related functions, and in an embodiment, may be determined through the syndrome check performed in the decoder of the LDPC code and decoding of an outer-concatenated CRC code.

A series of processes as described above is a scheme that reflects all possible guesses for bits having low reliability to an input of the decoder and then expects that iterative belief-propagation decoding for the input in which a correct guess is reflected will succeed. Such an opportunistic decoding operation is referred to by various names, and may be referred to as ensemble decoding, quasi maximum-likelihood (quasi-ML (QML)) decoding, afterburner decoding, saturate decoding, and/or an equivalent technical term. Hereinafter, in the present disclosure, embodiments are described by referring to such a technique as ensemble decoding.

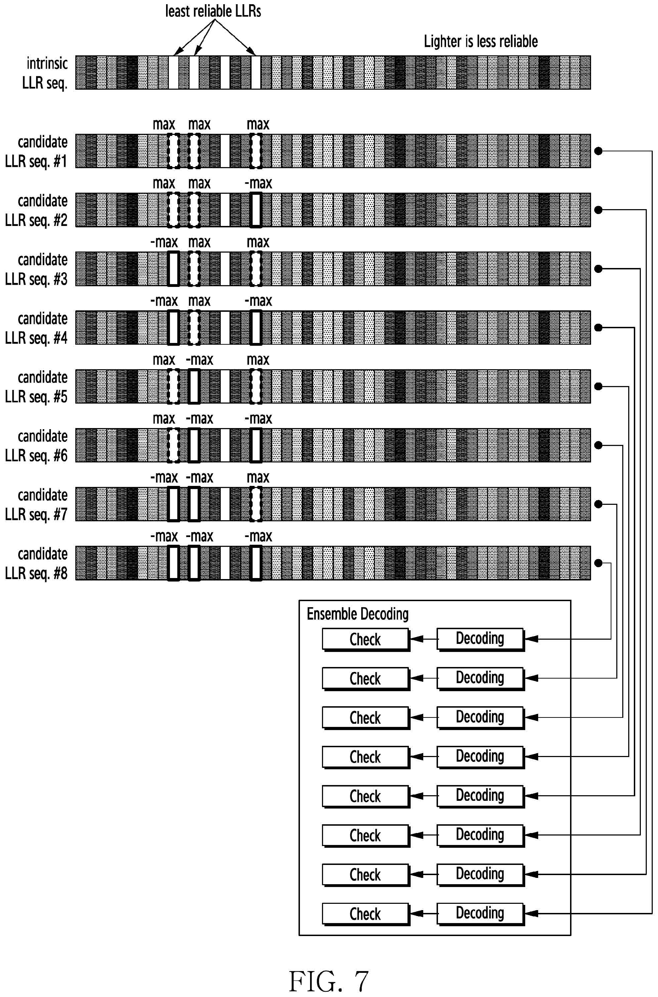

FIG. 7 illustrates an example of a procedure of ensemble decoding. FIG. 7 is a diagram for conceptually describing a process of an ensemble decoding technique in which an LLR having low reliability is guessed in all possible manners as in the above-described manner, and then validity of a result is checked by performing belief-propagation therefor.

Referring to FIG. 7, a conventional ensemble decoding operation starts from a process of finding *p* positions having low absolute values (or determined to be low) in all or a portion of a given intrinsic LLR sequence. This process may involve a sorting process for absolute values in all or a partial range of the given LLR sequence. For example, if the number of LLRs within a range (hereinafter, a search range) in which values may be changed in the intrinsic LLR sequence is ***N'***, finding *p* LLRs having low absolute values in the search range involves **Σ_{*k*=1,2*,...*,}*ₚN'* - *k*** times of value comparison operations. When ***p*** positions of the LLRs having the low absolute values are found as described above, a decoder (e.g., a component for LDPC decoding 660 in a reception device 600) generates 2*^{p}* modified candidate LLR sequences by modifying LLR values at the corresponding positions to preset positive and negative values. The preset positive and negative values may generally be determined as a maximum positive value and a minimum negative value used for LLR representation in the decoder, but are not necessarily limited thereto and may be determined as arbitrary positive or negative values within a representable range. For example, as illustrated in FIG. 7, if *p* is 3, eight modified candidate LLR sequences corresponding to all possible combinations may be generated.

The modified candidate LLR sequences as described above may be decoded independently. As described above, decoding of an LDPC code is performed through a belief-propagation process based on the intrinsic LLR sequence. Since the modified candidate LLR sequences are generated as all possible combinations for codeword bits, it is clear that one of them corresponds to correct codeword bits. Accordingly, a modified candidate LLR sequence in which an LLR absolute value is changed to a maximum or high value for correct codeword bits transmits an accurate message to other codeword bits by an iterative message passing decoding operation, and consequently a probability of decoding success increases. Accordingly, after performing decoding for each based on **2*^{p}*** modified candidate LLR sequences, if decoding is successfully completed by performing a syndrome check, a check by a concatenated CRC code, and the like, an estimation obtained by the decoding may be regarded as a result of a finally successful decoding. As described above, the decoder for the ensemble decoding may increase a decoding success probability and improve an error-correction performance by performing multiple decodings based on a plurality of modified candidate LLR sequences and combining results thereof.

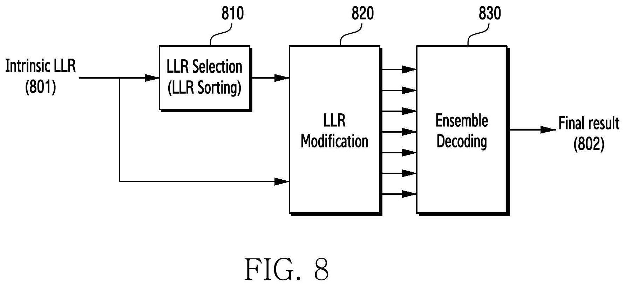

FIG. 8 illustrates a block diagram for ensemble decoding. A decoder (e.g., a component for LDPC decoding 660 in a reception device 600) may perform the ensemble decoding.

Referring to FIG. 8, for a given intrinsic LLR sequence 801, LLR selection 810 for finding a position at which a value of an LLR is to be changed is performed. In a conventional method, a process of finding a position having a low value by a predetermined ***p*** number by sorting an absolute value of the LLR may generally be used. When an LLR position to change a value is found, an LLR modification process 820 for generating a maximum of 2*^{p}* modified candidate LLR sequences for all combinations for this position is performed. The decoder may decode 830 each modified candidate LLR sequence, and may combine a result to output as a final result 802. If at least one of decodings performed based on the maximum of **2*^{p}*** modified candidate LLR sequences succeeds, the decoder may output a result of the success as the final result 802. Although a probability is low, if two or more decodings succeed, the decoder may output the final result 802 according to a pre-determined rule. If none of the decodings succeeds, the decoder may declare a decoding failure. In terms of that it is an LLR sequence input for decoding according to belief-propagation, the intrinsic LLR sequence 801 may be referred to as a first input sequence, and the modified candidate LLR sequences may be referred to as second candidate input sequences.

Hereinafter, a method of improving an ensemble decoding method and a device is presented based on various embodiments. A conventional ensemble decoding method determines a position of an LLR to change a value by sorting an element of the intrinsic LLR sequence. In the present disclosure, the following problem or improvable portion is identified in the conventional method.

- The conventional ensemble decoding method and the device identifies the position of the LLR to change the value based on the intrinsic LLR sequence. This method is seemingly reasonable, but may not guarantee improvement of a final decoding result.

- The conventional ensemble decoding method and the device performs an operation of comparing an absolute value of all LLRs in determining the position of the LLR to change the value. This operation is an operation that was not performed in a general decoding and causes additional complexity and delay.

Embodiments of the present invention improve the problem of the conventional ensemble decoding method and the device based on a structure and a feature of an LDPC code. Hereinafter, various embodiments of the present invention are introduced.

The ensemble decoding method and the device according to an embodiment of the present invention is characterized in that, in determining the LLR position to change the value based on the given intrinsic LLR sequence, a search range of the LLR to be a target to change the value is limited to information bits (or an information bit and a shortened bit) or is limited to a partial area determined to be helpful for belief-propagation decoding.

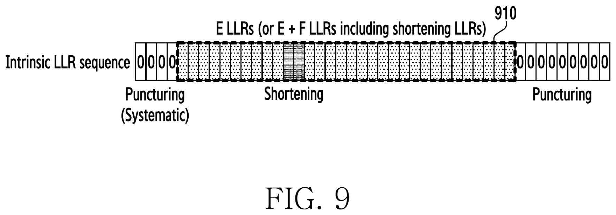

FIG. 9 illustrates an example of a search range of a position of an LLR to be changed in ensemble decoding.

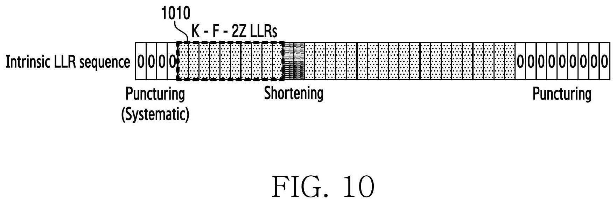

FIG. 10 illustrates an example of a limitation of a position of an LLR to be changed in ensemble decoding.

Referring to FIG. 9, in a conventional scheme, an entire range 910 excluding a punctured bit position from a given intrinsic LLR is considered as a search range. The entire range 910 may include positions of bits transmitted through a wireless channel and positions of bits shortened by zero filling 530. The number of LLRs within the search range may be a minimum of *E* which is the number of bits transmitted through a channel (i.e., a rate matching bit length). Since an LLR for the shortened bit is set to a large value corresponding to a bit 0, even if the LLR for the shortened bit is included in the search range, there may be no difference in a final result of decoding. Accordingly, for convenience of implementation, a position having the LLR may be determined by considering *E + F* consecutive range as the search range including the LLR for *F* shortened bits. If there is no punctured bit, the number of LLRs corresponding to the search range may be a maximum of *N* - 2*Z* excluding a systematic puncturing bit position.

Referring to FIG. 10, a method and a device according to embodiments of the present disclosure may limit a search range for the LLR to change a value to a portion within positions of bits transmitted through the wireless channel (hereinafter, a transmission area) by considering a characteristic of a bit and a configuration of a code. For example, in a 3GPP NR system, the decoder may determine at least a portion of remaining information bits excluding systematic puncturing bits and shortened bits as the search range for the LLR to change the value. The decoder may select *p* LLR positions in the search range. In this case, the number of bits within the search range for finding the LLR to change the value is *K - F -* 2*Z* excluding 2*Z* systematic puncturing bits and *F* shortened bits from *K* entire systematic parts. According to this embodiment, regardless of a code rate of an LDPC code used (i.e., regardless of the number of parity bits), a size of the search range for finding the LLR to change the value may be fixed to *K - F* - 2*Z* as illustrated in FIG. 10. The size of the search range is smaller than *E.* Since the method according to this embodiment finds the LLR to change the value in a search range smaller than a conventional search range (e.g., E+F or E), it may be implemented and realized with lower complexity and delay.

As described above, a reason for determining a range of the information bits excluding the punctured bits and the shortened bits as the search range for the LLR to change the value in an embodiment of the present invention is that a general LDPC code is designed to preferentially improve information bits rather than parity bits. For example, a 3GPP NR LDPC code is designed with a goal of error correction and recovery for the information bits, and accordingly, VNs corresponding to the information bits are designed to receive a message from more neighboring CNs. In other words, the LDPC code is designed such that VNs corresponding to the information bits have a high degree. If an absolute value of an information bit LLR corresponding to the VN having the high degree is large, it may have more positive influence on other bits in iterative message passing by the belief-propagation. The decoder according to an embodiment of the present disclosure may determine a search range to change an LLR value of the information bit corresponding to the VN having the high degree.

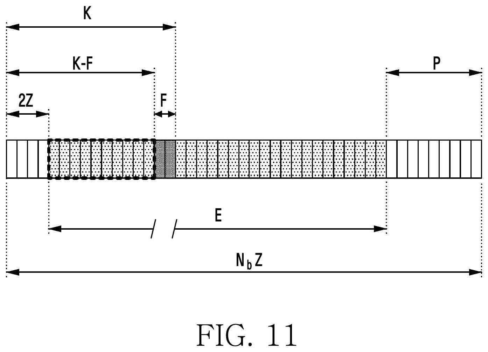

FIG. 11 illustrates an example of a limitation of a position of an LLR to be changed for ensemble decoding in an intrinsic log likelihood ratio (LLR) sequence including a systematic puncturing bit. In FIG. 11, in a case that an intrinsic LLR sequence includes an LLR for 2*Z* systematic puncturing bits, a search range of an LLR to change a value is specifically illustrated according to the embodiment of the present invention.

Referring to FIG. 11, an index of the systematic puncturing bits is from 0 to 2*Z* - 1. An index of the search range according to the limitation of the position of the LLR to be changed described through FIG. 10 starts from next to the systematic puncturing bits and may be before shortened bits according to zero filling (e.g., zero filling 530). For example, the index of the search range may be **[2*Z*, *K - F*) = [2*Z*, *K* - *F* - 1].**

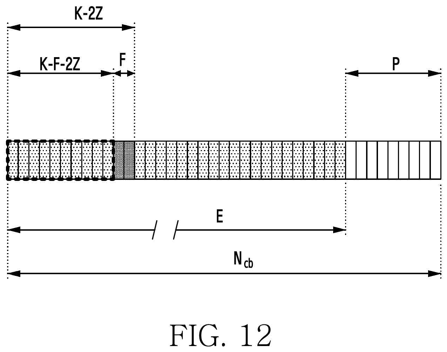

FIG. 12 illustrates an example of a limitation of a position of an LLR to be changed for ensemble decoding in an intrinsic LLR sequence not including a systematic puncturing bit. In FIG. 12, in a case that an intrinsic LLR sequence does not include an LLR for the systematic puncturing bit, a search range of an LLR to change a value based on the intrinsic LLR sequence is specifically illustrated according to embodiments of the present disclosure.

Referring to FIG. 12, since the systematic puncturing bit does not exist, an index of the search range according to the limitation of the position of the LLR to be changed described through FIG. 10 may start from 0. For example, the index of the search range may be **[0, *K* - *F* - 2*Z*) *=* [0, *K - F -* 2*Z* - 1].** As a non-limiting example, for convenience of implementation, the search range may be determined to include ***F*** shortened bits. In this case, the index of the search range may be **[0, *K -* 2*Z*) = [0, *K* - 2*Z* - 1].**

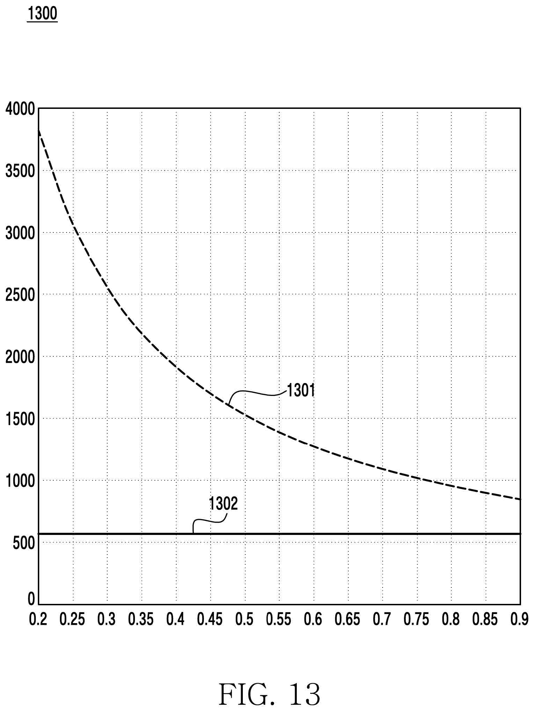

FIG. 13 illustrates an example of performance according to a limitation of a position of an LLR to be changed for ensemble decoding. In FIG. 13, in a case that a code dimension ***K*** is 256 in a 5G NR LDPC code system, an operation complexity of a conventional method (e.g., the search range of FIG. 9) (hereinafter, a first scheme) in which a search range is determined to find an LLR to change ***p* = 3** values and a method of an embodiment of the present disclosure (e.g., the search range of FIG. 10, or the limitation of the LLR position) (hereinafter, a second scheme) is illustrated.

Referring to FIG. 13, a graph 1300 indicates a code rate and a sorting complexity. In each of the first scheme and the second scheme, ***p* = 3** positions of LLR in order of a small absolute value may be identified. For example, if a size of the search range is *S*, *S* - 1. times of comparison operations may be required to find an LLR having the smallest absolute value. To find an LLR having the next smallest absolute value, *S* - 2 times of comparison operations may be required for remaining elements excluding the LLR having the smallest absolute value found previously. In summary, in a case of using the method, a total number of comparison operations performed to find *p* LLR positions having the smallest absolute value in the search range of the size *S* may be **Σ_{*k*=1,...*p*}(*s* - *k*).**

A horizontal axis of the graph 1300 indicates a code rate. For example, if the code rate is low, more parity bits are generated and a rate matching length *E* becomes large, and if the code rate is high, fewer parity bits are generated and the rate matching length *E* becomes small. A vertical axis of the graph 1300 indicates sorting complexity. For example, the sorting complexity indicates a total number of comparison operations performed to find ***p =* 3** LLR positions having the smallest absolute value in the search range. A first line 1301 indicates the total number of comparison operations according to the first scheme, and a second line 1302 represents the total number of comparison operations according to the second scheme. As can be seen through a comparison of the first line 1301 and the second line 1302, it may be confirmed that the second scheme according to the embodiment of the present disclosure performs a smaller number of comparison operations than the first scheme. The smaller number of comparison operations indicates lower complexity, and it may be confirmed that the second scheme indicates almost the same complexity (e.g., the number of comparison operations) regardless of the code rate.

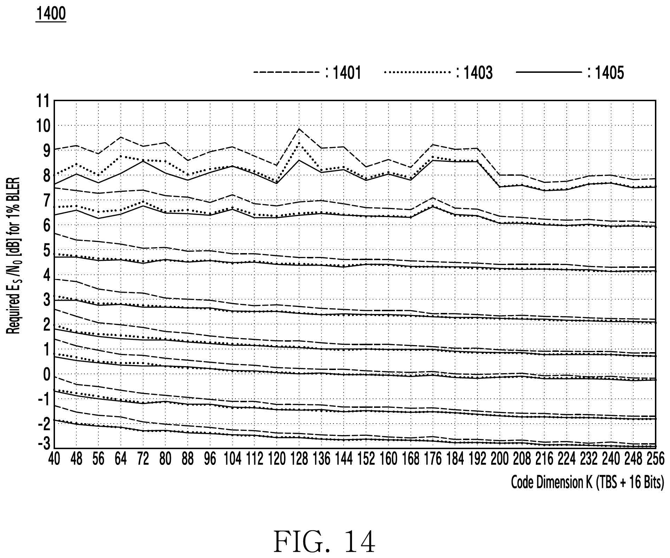

FIG. 14 illustrates an example of a performance according to a limitation of a position of an LLR to be changed for ensemble decoding. In FIG. 14, a result of evaluating an error-correction performance of a conventional method (e.g., a first scheme) and a method (e.g., a second scheme) using the limitation of the position of the LLR to be changed according to embodiments of the present disclosure according to a code dimension and a code rate in a 5G NR LDPC code system is illustrated.

Referring to FIG. 14, a graph 1400 indicates an error-correction performance for each code dimension. A horizontal axis of the graph 1400 indicates a code dimension *K* , and a vertical axis of the graph 1400 indicates *Eₛ*/*N*₀ dB value which is a signal-to-noise ratio (SNR) to achieve a required block error rate (BLER) of 1%.

All individual points of FIG. 14 may be confirmed through an experiment for obtaining a BLER curve. If *Eₛ*/*N*₀ which is a value of a Y-axis and achieves the BLER of 1% is small, it means that the same BLER may be achieved with less energy, and therefore, as the corresponding value is smaller, a superior error-correction performance is represented. A figure evaluating the error-correction performance as in FIG. 14 is useful for effectively indicating an experiment for various code parameters (a code dimension, or a code rate), and in the present disclosure, the same may be used when describing an effect of another embodiment.

The graph 1400 includes experimental results for various code rates. For example, the graph 1400 may include an error-correction performance of general decoding 1401 which is not the ensemble decoding, an error-correction performance of ensemble decoding 1403 according to the first scheme, and an error-correction performance of ensemble decoding 1405 according to the second scheme. Each curve means an experiment for code parameters having the same code rate. According to an ensemble decoding method according to the first scheme and the second scheme, a decoder finds *p* = 3 LLR positions having low absolute values in an intrinsic LLR sequence, and generates 2*^{p}* = 8 modified candidate LLR sequences by changing a value of the LLR at the corresponding positions into all possible patterns, and then attempts decoding.

In other words, the first scheme and the second scheme are different only in positions where LLR values are changed, and at the corresponding positions, generating modified candidate LLR sequences through all possible patterns (indicating a combination of numbers of cases possible by dividing a value of each position into 0 and 1), and obtaining a final decoding result through decoding for each candidate LLR sequence (in other words, the ensemble decoding) are identical. In other words, the first scheme and the second scheme have a difference in that a search range for finding the LLR position to be changed is differently set for the ensemble decoding. For reference, the graph 1400 also includes a result of general decoding (or normal BP) to which the ensemble decoding is not applied.

As illustrated in FIG. 14, the decoder according to embodiments of the present disclosure may provide the almost identical error-correction performance with low complexity by considering a relatively small search range, instead of considering an entire area (e.g., bits according to rate matching) (or a area further including shortened bits by zero filling 530 in addition to the entire area of the transmitted bits) of bits transmitted through a wireless channel. As confirmed through the graph 1300 of FIG. 13 and the graph 1400 of FIG. 14, according to an embodiment, as the search range is limited according to a lifting size for LDPC (e.g., Z) and the number of bits (e.g., K or KbZ) to be encoded in a code block, the same error-correction performance may be achieved with a smaller number of operations. For example, the decoder may determine the search range based on the lifting size and the number of bits to be encoded. As an example, the size of the search range may be a value obtained by subtracting two times of the lifting size from the number of bits to be encoded. This is because two times of the lifting size is punctured among a systematic part of an encoding area (e.g., N). Within the search range, a designated number of change areas (in other words, positions where LLR values are changed) may be determined. For example, the change areas may be determined as positions corresponding to top p bits having low absolute values of LLR among the bits of the search range.

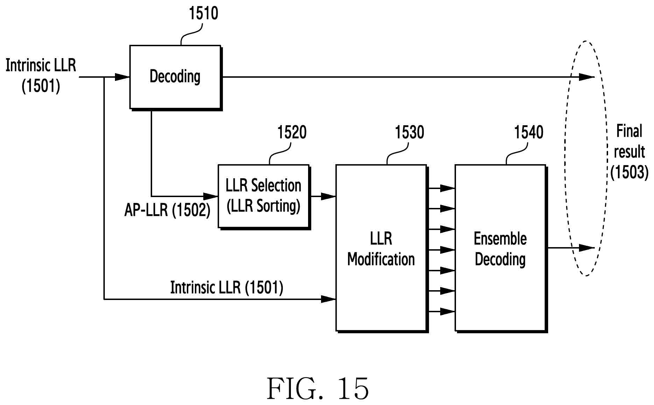

FIG. 15 illustrates a block diagram for a limitation of a position of an LLR to be changed according to a posteriori LLR sequence. An ensemble decoding method and a device according to an embodiment of the present disclosure determine the position of the LLR to be changed based on an AP-LLR sequence finally obtained when decoding fails after attempting decoding based on a given intrinsic LLR sequence. In other words, a search range (or the position of the LLR to be changed for the ensemble decoding) described through FIG. 8 to FIG. 14 may be limited based on the obtained AP-LLR sequence. A decoder performs decoding based on the intrinsic LLR sequence, and performs pre-compensation by identifying whether which position of an LLR does not converge and the decoding fails through a result of the decoding. In the embodiment, a decoding performance may be improved by changing an LLR which decisively contributes to final decoding failure.

Referring to FIG. 15, first, general decoding 1510 may be performed for a given intrinsic LLR sequence 1501. If the decoding 1510 succeeds, a result obtained from the decoder is output as a final result 1503. If the decoding 1510 fails, the decoder may obtain an AP-LLR 1502 updated by iterative belief-propagation decoding.

The decoder according to embodiments performs LLR selection 1520 for determining a position of an LLR to change a value for the ensemble decoding based the AP-LLR 1502. A method for determining the position of the LLR to change the value based on the AP-LLR 1502 may be implemented through various detailed operations, and embodiments of the present disclosure are not limitedly interpreted to any specific method. For example, *p* positions of LLRs predetermined to change the value may be determined based on absolute values of each element of an AP-LLR sequence. For example, *p* positions having the smallest absolute values may be determined. When the position of the LLR to change the value, in other words, a change area is determined, the decoder may generate 2*^{p}* modified candidate LLR sequences 1530 by expanding a value at the corresponding position of the given intrinsic LLR sequence 1501 into possible candidates (e.g., an LLR value corresponding to 0, or an LLR value corresponding to 1).

The decoder according to embodiments of the present disclosure selects the position of the LLR to change the value based on an updated AP-LLR sequence after performing the iterative belief-propagation for a preset maximum number of decoding iterations, and this part is differentiated from a conventional scheme (in other words, a first scheme). This scheme may be referred to as a third scheme in the present disclosure. The decoder according to embodiments of the present disclosure generates the modified candidate LLR sequences by changing the element at the corresponding position of the intrinsic LLR sequence 1501 even if the position of the LLR to change the value is determined based on the AP-LLR sequence. In other words, the modified candidate LLR sequences may be generated by replacing values at each position of the change area with candidate values (e.g., an LLR value corresponding to 0, or an LLR value corresponding to 1) based on the intrinsic LLR sequence 1501. In terms of being an LLR sequence input for decoding according to the belief-propagation, the intrinsic LLR sequence 1501 may be referred to as a first input sequence, and the modified candidate LLR sequences may be referred to as second candidate input sequences.

In the scheme for determining the position of the LLR to change the value based on the AP-LLR sequence (i.e., the third scheme) according to embodiments of the present disclosure, a search range of the AP-LLR sequence may be determined by a scheme different from the first scheme. In a conventional method, an intrinsic LLR sequence used as a target of search includes an LLR (a value 0) for a punctured bit, and this is not considered as a position of the LLR to change the value. However, the third scheme according to embodiments of the present disclosure is based on the AP-LLR sequence obtained after decoding. Among all encoded bits, an AP-LLR for a punctured bit may be updated by the iterative belief-propagation operation.

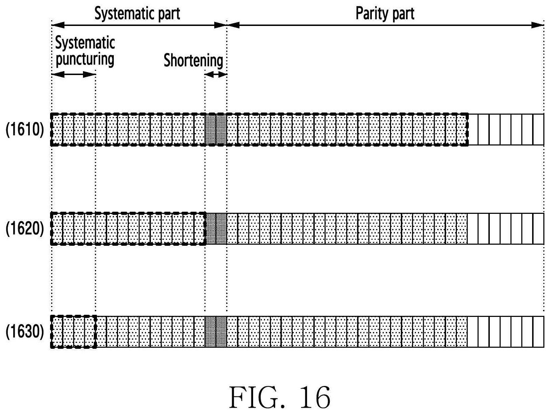

Due to the update, unlike an LLR position selection method based on the intrinsic LLR sequence 1501, the punctured bit may be understood as a position that may significantly affect an actual decoding performance. In the third scheme, the punctured bit may also be considered as a position at which a value of the LLR may be changed. According to the third scheme, punctured bits considered as positions at which values may be changed for the ensemble decoding may include a systematic puncturing bit (e.g., an information bit) and a general puncturing bit (e.g., a parity bit). Examples of FIG. 16 are described for description of punctured bits.

FIG. 16 illustrates examples of a limitation of a position of an LLR to be changed according to a posteriori LLR sequence. In FIG. 16, examples of a search range according to the third scheme are illustrated.

Referring to FIG. 16, an AP-LLR sequence (e.g., an AP-LLR sequence 1502) may be largely divided into a systematic part (e.g., a part for an information bit) and a parity part. The systematic part may be further divided into a systematic punctured part, a shortened part, and a remaining part. The parity part may be divided into a part in which LLR is updated by iterative decoding and a part in which LLR is not updated. The AP-LLR sequence may be a result in which decoding according to belief-propagation is performed. The decoding according to the belief-propagation may include a VN update and a CN update. Probability update according to the VN update and the CN update may be performed according to the [Equation 6] to the [Equation 12] described above. A length of the AP-LLR sequence is the same as N which is a length of a mother code vector for an LDPC code. The AP-LLR sequence may be divided into the systematic part (e.g., the part for the information bit) and the parity part. According to a lifting size set for the LDPC code, a portion of bits among bits of a total code length N are punctured. The punctured bit is set to have an LLR value corresponding to '0', but variable nodes corresponding to punctured bits may be updated through the belief-propagation decoding. Due to the update, an LLR of a variable node corresponding to at least one of the punctured bits may no longer be fixed. In other words, an LLR for a portion or all of punctured bits may be updated by an iterative belief-propagation decoding operation. Since bits punctured in the systematic part correspond to an information bit, restoration of the information bit part should be performed, and thus an AP-LLR of the corresponding part may be necessarily updated.

Referring to a first example 1610, a decoder may determine a position of an LLR to change a value by using all ranges in which the AP-LLR is updated as a search range. All ranges in which the AP-LLR is updated correspond to the entire systematic part and an area excluding a punctured part among the parity part. The search range may include systematic puncturing bits, remaining systematic bits, parity bits in which the AP-LLR is updated, and shortened bits. In the first example 1610, a change area is illustrated as including an area of the shortened bits according to zero filling (e.g., zero filling 530), but embodiments of the present disclosure are not limited thereto. The AP-LLR for shortened bits does not generally affect determining the position of the LLR to be changed. As a non-limiting example, the search range, in other words, the change area may not include the area of the shortened bits according to the zero filling (e.g., the zero filling 530).

Referring to a second example 1620, the decoder may determine the position of the LLR to change the value by using an LLR of a systematic range in which the AP-LLR is updated as a search range. The search range may include systematic puncturing bits, remaining systematic bits, and shortened bits. In other words, the decoder according to the second example 1620, unlike the first example 1610, may exclude an area corresponding to parity bits in which the AP-LLR is updated from the search range for the ensemble decoding. In the second example 1620, the search range is illustrated as including the area of the shortened bits according to the zero filling (e.g., the zero filling 530), but embodiments of the present disclosure are not limited thereto. The AP-LLR for the shortened bits does not generally affect determining the position of the LLR to be changed. As a non-limiting example, the search range, in other words, the search range may not include the area of the shortened bits according to the zero filling (e.g., the zero filling 530).

Referring to a third example 1630, the decoder may determine the position of the LLR change the value by using an LLR for a systematic puncturing bit in which the AP-LLR is updated as a search range. The search range may include all or a portion of systematic puncturing bits. As an example, a 3GPP NR LDPC code is designed such that restoration of the systematic puncturing bits is effectively performed, and accordingly, VNs corresponding to the systematic puncturing bits are designed to receive a message from more neighboring CNs. In other words, the LDPC code is designed such that the VNs corresponding to the systematic puncturing bits have a high degree. When an absolute value of an information bit LLR corresponding to the VNs having the high degree is large, more positive influence may be exerted on other bits in iterative message passing according to the belief-propagation. The embodiment of the present disclosure determines the search range to change an LLR value of an information bit corresponding to the VNs having the high degree based on this basis. According to an embodiment, the decoder may determine at least a portion of the systematic puncturing bits as a change area for the ensemble decoding. For example, the decoder may identify at least one VN according to a degree of a base graph for the LDPC code among variable nodes corresponding to the systematic puncturing bits. As an example, the decoder may identify top X VNs when sorted based on a degree. As another example, the decoder may identify VNs having a degree equal to or greater than a threshold value. The decoder may determine a bit position corresponding to the identified VN as a decoding area for the ensemble decoding.

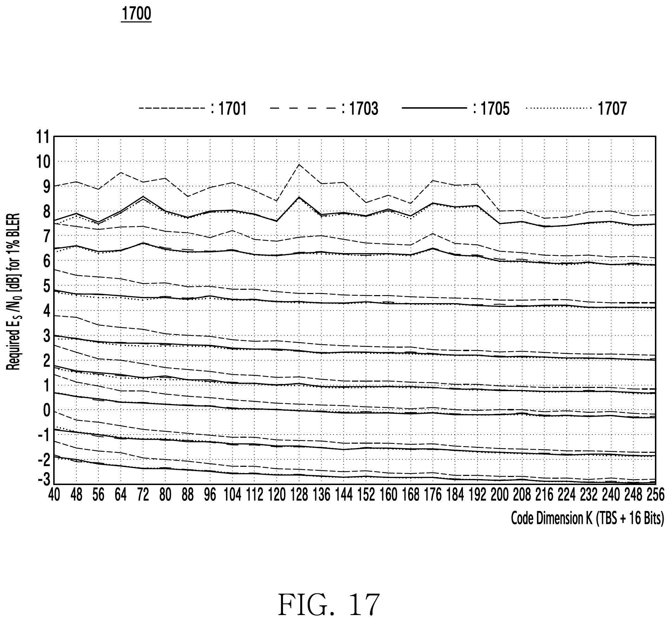

FIG. 17 illustrates an example of a performance of a limitation of a position of an LLR to be changed according to a posteriori LLR sequence. In FIG. 17, a result of evaluating an error-correction performance of a conventional method (e.g., a first scheme) and a method (e.g., a third scheme) using the limitation of the position of the LLR to be changed by using an AP-LLR according to embodiments of the present disclosure according to a code dimension and a code rate in a 5G NR LDPC code system is illustrated.

Referring to FIG. 17, a graph 1700 indicates an error-correction performance for each code dimension. A horizontal axis of the graph 1700 indicates a code dimension *K*, and a vertical axis of the graph 1700 indicates ***Eₛ*/*N*₀** dB value which is a signal-to-noise ratio (SNR) to achieve a required block error rate (BLER) of 1%. The graph 1700 includes an experimental result for various code dimensions. For example, the graph 1700 may include an error-correction performance of general decoding 1701 which is not ensemble decoding, an error-correction performance of ensemble decoding 1705 according to a first example 1610 of the third scheme, an error-correction performance of ensemble decoding 1703 according to a second example 1620 of the third scheme, and an error-correction performance of ensemble decoding 1707 according to a third example 1630 of the third scheme. Each curve means an experiment for code parameters having the same code rate. According to an ensemble decoding method according to the third scheme, a decoder finds ***p* = 3** LLR positions having low absolute values in each search range of an AP-LLR sequence, and generates 2*^{p}* = 8 modified candidate LLR sequences by changing a value of the LLR at the corresponding position into all possible patterns, and attempts decoding. The graph 1700 also includes a result of general decoding (normal BP) to which the ensemble decoding is not applied.

As illustrated in FIG. 17, it may be confirmed that the almost similar error-correction performance is achieved for various code dimensions and code rates even when search ranges are differently set according to the examples (e.g., the first example 1610, the second example 1620, and the third example 1630) of the third scheme. Since the search range of the third example 1630 is the narrowest, ensemble decoding according to the third example 1630 may be advantageous in implementation in terms of providing the same and/or similar performance with low complexity.

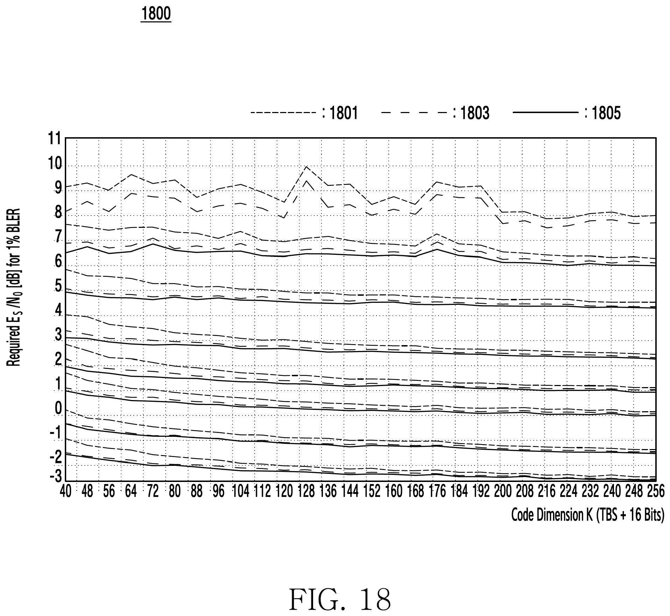

FIG. 18 illustrates an example of a performance of a limitation of a position of an LLR to be changed according to a posteriori LLR sequence. In FIG. 18, a result of evaluating error-correction performances of two embodiments of the present disclosure for determining a position of an LLR to change a value based on an intrinsic LLR and an AP-LLR in a 5G NR LDPC code system is illustrated.

Referring to FIG. 18, a graph 1800 indicates an error-correction performance for each code dimension. A horizontal axis of the graph 1800 indicates a code dimension *K,* and a vertical axis of the graph 1800 indicates *Eₛ*/*N*₀ dB value which is a signal-to-noise ratio (SNR) to achieve a required block error rate (BLER) of 1%. The graph 1800 includes an experimental result for various code dimensions. For example, the graph 1800 may include an error-correction performance of general decoding 1801 which is not ensemble decoding, an error-correction performance of ensemble decoding 1803 according to the second scheme, and an error-correction performance of ensemble decoding 1805 according to a third example 1630 of the third scheme.

According to ensemble decoding methods (e.g., the ensemble decoding according to the second scheme and the ensemble decoding according to the third scheme) according to the two schemes, a decoder finds *p* = 3 LLR positions having low absolute values in each of an intrinsic LLR sequence and an AP-LLR sequence, and generates 2*^{p}* = 8 modified candidate LLR sequences by changing a value of the LLR at the corresponding positions into all possible patterns, and attempts decoding. In a scheme based on the intrinsic LLR sequence (i.e., the second scheme), systematic bits which are not punctured are determined as a search area. In a scheme based on the AP-LLR sequence (i.e., the third scheme), systematic puncturing bits are determined as a search area. In both of the two schemes, as described above, a value of an LLR of a bit index of a change area in the intrinsic LLR sequence are replaced with a candidate value. In a case that the number of bit indices of the change area is 4, a total of 16 candidate patterns may be formed. Based on the intrinsic LLR sequence, as the 16 candidate patterns for the change area are applied, the decoder may generate 16 candidate input sequences. The decoder may obtain a final decoding result by performing decoding for each candidate input sequence of at least a portion of the candidate input sequences.

As illustrated in FIG. 18, it may be confirmed that a method for determining the change area based the AP-LLR according to embodiments of the present disclosure achieves a more superior performance (i.e., the lower curve in FIG. 18) than a method for determining the change area based on the intrinsic LLR. However, since one decoding is performed based on the intrinsic LLR, a method (e.g., the third scheme) for determining the position of the LLR to change the value based on the AP-LLR may have higher complexity and delay than a method (e.g., the second scheme) based on the intrinsic LLR. Therefore, one of the two methods may be effectively selected according to a condition, an environment, and a requirement of an LDPC code system.

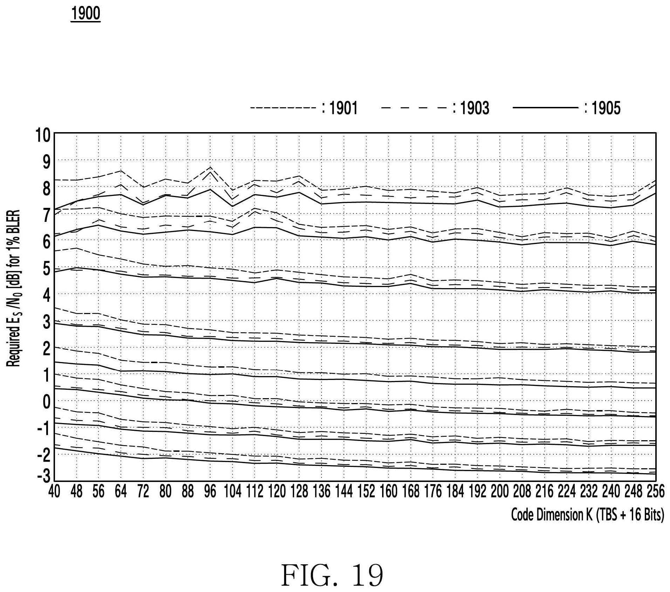

FIG. 19 illustrates an example of a performance of a limitation of a position of an LLR to be changed according to a posteriori LLR sequence. In FIG. 19, a result of evaluating an error-correction performance of two embodiments of the present disclosure for determining a position of an LLR to change a value based on an intrinsic LLR and an AP-LLR in a 4G LTE turbo code system is illustrated.

Referring to FIG. 19, a graph 1900 indicates an error-correction performance for each code dimension. A horizontal axis of the graph 1900 indicates a code dimension *K*, and a vertical axis of the graph 1900 indicates *Eₛ*/*N*₀ dB value which is a signal-to-noise ratio (SNR) to achieve a required block error rate (BLER) of 1%. The graph 1900 includes an experimental result for various code dimensions. For example, the graph 1900 may include an error-correction performance of general decoding 1901 which is not ensemble decoding, an error-correction performance of ensemble decoding 1903 according to the second scheme, and an error-correction performance of ensemble decoding 1905 according to a third example 1630 of the third scheme.

According to ensemble decoding methods (e.g., the ensemble decoding according to the second scheme and the ensemble decoding according to the third scheme) according to the two schemes, a decoder finds *p* = 3 LLR positions having low absolute values in each of an intrinsic LLR sequence and an AP-LLR sequence, and generates 2*^{p}* = 8 modified candidate LLR sequences by changing a value of the LLR at the corresponding positions into all possible patterns, and attempts decoding. In a scheme based on the intrinsic LLR sequence (i.e., the second scheme), systematic bits which are not punctured are determined as a search area. In a scheme based on the AP-LLR sequence (i.e., the third scheme), all systematic bits are determined as a search area. In both of the two schemes, as described above, a value of an LLR of a bit index of a change area in the intrinsic LLR sequence are replaced with a candidate value. When the number of bit indices of the change area is 4, a total of 16 candidate patterns may be formed. Based on the intrinsic LLR sequence, as the 16 candidate patterns for the change area are applied, the decoder may generate 16 candidate input sequences. The decoder may obtain a final decoding result by performing decoding for each candidate input sequence of at least a portion of the candidate input sequences.

As illustrated in FIG. 19, it may be confirmed that a method for determining the change area based on the AP-LLR according to embodiments of the present disclosure achieves a more superior performance (i.e., the lower curve in FIG. 19) than a method for determining the change area based on the intrinsic LLR. However, since one decoding is performed based on the intrinsic LLR, a method (e.g., the third scheme) for determining a position of an LLR to change a value based on the AP-LLR may have higher complexity and delay than a method (e.g., the second scheme) based on the intrinsic LLR. Therefore, one of the two methods may be effectively selected according to a condition, an environment, and a requirement of a turbo code system.

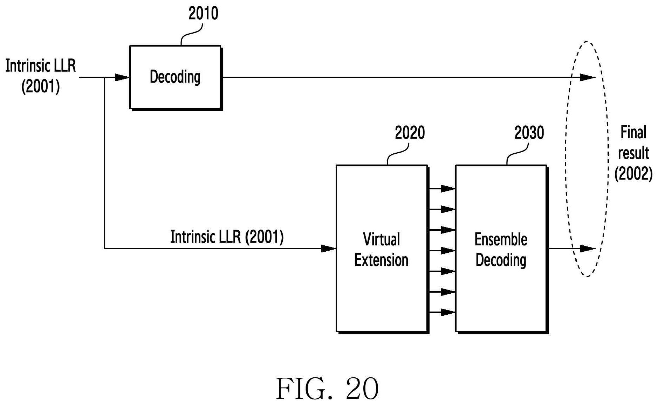

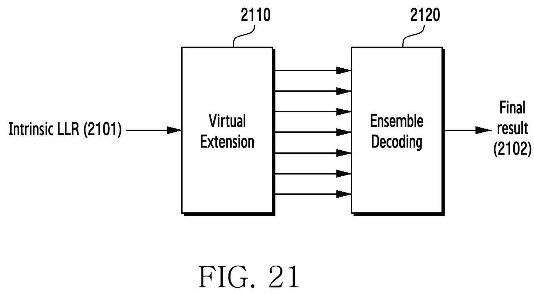

FIG. 20 and FIG. 21 are block diagrams for ensemble decoding using signal extension. A span decoding method and a device according to an embodiment of the present disclosure perform decoding by adding a virtual LLR value at a punctured bit position of a given intrinsic LLR sequence. That is, the embodiment performs decoding at a changed position of an area spaced by the same distance due to a virtual signal based on a reception signal. In this case, a range in which a signal is added may be selected by including punctured bits in a systematic (e.g., an information bit) or punctured bits in a parity. Such a scheme (hereinafter, a fourth scheme) provides an effect of lowering a code rate as a parity bit of a finally given signal is virtually extended, and this means improvement of a decoding performance compared to a conventional case.

Referring to FIG. 20, general decoding 2010 is performed for a given intrinsic LLR sequence 2001. If the decoding 2010 succeeds, an estimation obtained from a decoder is output as a final result 2002. Although not illustrated in FIG. 20, if the decoding 2010 fails, the intrinsic LLR sequence 2001 may be used for virtual extension 2020. The decoder virtually adds an LLR value at a puncturing bit position of a given signal. At this time, a position at which a value is changed may be selected arbitrarily or by reflecting a structural characteristic of a code without using an intrinsic LLR value of the given signal and values calculated due to decoding.

Referring to FIG. 21, unlike FIG. 20, without performing the general decoding, the decoder may directly perform the virtual extension 2020 from a given LLR sequence (e.g., an intrinsic LLR sequence 2101). The decoder may virtually add an LLR value to at least one of puncturing bits of the given LLR sequence (e.g., the intrinsic LLR sequence 2101). The decoder according to embodiments of the present disclosure may use both a scheme according to FIG. 20 and a scheme according to FIG. 21.

A method (hereinafter, the fourth scheme) for determining the position at which the virtual LLR is added at the punctured bit may be implemented through various operations, and the decoder of the present disclosure is not limited to any specific method. As an example, positions of a pre-determined *q* positions of LLRs to which a value is to be added may be sequentially determined within a punctured bit sequence. That is, the smallest *q* positions in the punctured parity bit index may be determined. If the puncturing bit position of the LLR to which a value is to be added is determined, the decoder may perform ensemble decoding 2030. The decoder may generate a maximum of 2*^{q}* modified candidate LLR sequences by adding the value to the given intrinsic LLR sequence 2101.

The decoder according to an embodiment of the fourth scheme may select the position at which the LLR value is to be added based on the positions of the puncturing bits of the given LLR sequence (e.g., the intrinsic LLR sequence 2001). The fourth scheme may be understood as finding positions for additionally generating candidate patterns for ensemble decoding in addition to the given LLR sequence, rather than limiting the positions to change the LLR values for the ensemble decoding within the given LLR sequence.

As in FIG. 8, in the conventional first scheme, for the given intrinsic LLR sequence 801, the LLR selection 810 for finding a position at which a value of an LLRs is to be changed is performed. For example, generally, a process of finding a position having a low value by the predetermined *q* by sorting absolute values of the LLR is used. On the other hand, the decoder according to the fourth scheme determines a position according to a configuration of a code or arbitrarily without going through this search process. For example, in a 3GPP NR system, the decoder may consider systematic puncturing bits and general puncturing bits as a search range of the LLR to change the value. The decoder may select the pre-determined *q* LLR positions in the search range. In this case, a specific position at which the value in the search range is to be changed is determined in consideration of a structure and an implementation of a code. As one example among various methods, in a 3GPP NR LDPC code, in consideration of convenience of operation, a single degree parity bit is designed to be sequentially extended to support various code rates. If the virtual signal is added sequentially from a low index in a punctured parity part, the LDPC code may obtain an effect of lowering the code rate compared to the given signal as the parity is extended. Alternatively, a signal may be added by randomly selecting from punctured bit positions by the predetermined number.

In embodiments of the present disclosure, by adding the virtual signal to the parity puncturing bit, a code extension may be preferentially applied compared to the systematic puncturing bit. The systematic puncturing bit may be determined as a change area for changing the LLR value after the parity puncturing bit is changed. For example, in a case that the number of additionally punctured bits is smaller than q which is a size (e.g., the number of bits corresponding to the change area) of the change area, virtual signals by the number of *q* - *P* may be added, or another previously proposed scheme (e.g., ensemble decoding within K-2Z bit positions in a transmitted area or ensemble decoding after a first decoding result) may be applied. The above-described span decoding operates only on the punctured bit position, and in a case that there is no punctured bit position, at least one of the other schemes is performed, so that a decoding performance may be improved.

In an embodiment of the present disclosure, since a process of selecting the position at which the value is to be changed by using the intrinsic or the AP LLR is omitted, as an implementation and a realization process are simplified, implementation complexity and delay according to the decoding may be reduced.

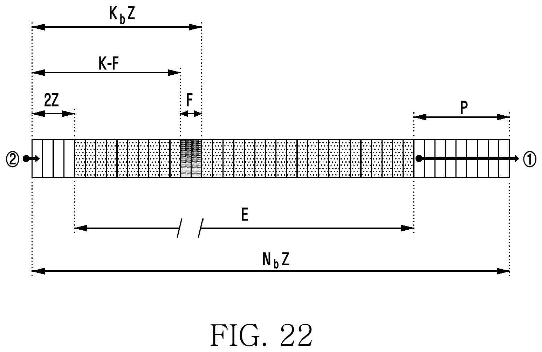

FIG. 22 to FIG. 25 illustrate examples of ensemble decoding using signal extension. In FIG. 22 to FIG. 25, an area in which an LLR value is to be changed according to a fourth scheme is illustrated.

Referring to FIG. 22, an intrinsic LLR sequence may have a length of an entire N_{b}Z. The length of the entire N_{b}Z may correspond to a code length N. N_{b} may be determined according to a base graph for an LDPC code. For example, the code length may be 66Z or 50Z according to the base graph. The Z may correspond to a lifting size for the LDPC code. In a case that the intrinsic LLR sequence includes an LLR for 2*ZP* systematic puncturing bits and an LLR for a total of *P* punctured parity bits, in FIG. 22, *q* at which values may be changed are specifically illustrated. An index 0 of a bit of the intrinsic LLR sequence may start from a punctured systematic puncturing bit. For example, a change area *S* is obtained through Equation 13 below. ${S}_{i} = \left(E+2Z+F+i\right) mod {N}_{b} Z for i = 0 , 1 , … , q - 1$

S*ᵢ* indicates a bit index of an i-th position in the change area. N_{b}Z may correspond to a code length N. Z may correspond to a lifting size for the LDPC code. E indicates the number of bits (e.g., the number of bits transmitted through a wireless channel) according to a code rate matching, and F indicates the number of bits shortened according to zero filling (e.g., zero filling 530). q indicates a size of the change area.

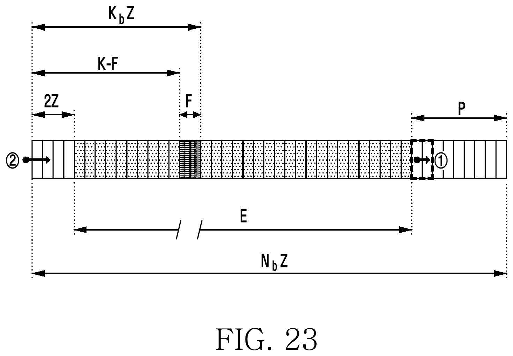

Referring to FIG. 23, the intrinsic LLR sequence may have the length of the entire N_{b}Z. The length of the entire N_{b}Z may correspond to the code length N. N_{b} may be determined according to the base graph for the LDPC code. For example, the code length may be 66Z or 50Z according to the base graph. The Z may correspond to the lifting size for the LDPC code. In a case that the intrinsic LLR sequence includes an LLR for the systematic puncturing bit but does not include all punctured parity bits, in FIG. 23, *q* LLR positions at which values may be changed are specifically illustrated. Unlike FIG. 22, when the parity bits are grouped by *Z*, groups that do not include even one bit having the given LLR value may be excluded from a selection area for improvement of implementation and latency. Specifically, Equation 14 may indicate an LLR change area determined according to an embodiment. ${S}_{i} = \left(E+2Z+F+i\right) mod \left(\left⌈\frac{E + 2 Z + F}{Z}\right⌉\times Z\right) for i = 0 , 1 , … , q - 1$

S*ᵢ* indicates the bit index of the i-th position in the change area. N_{b}Z may correspond to the code length N. Z may correspond to the lifting size for the LDPC code. E indicates the number of bits (e.g., the number of bits transmitted through the wireless channel) according to the code rate matching, and F indicates the number of bits shortened according to the zero filling (e.g., the zero filling 530). q indicates the size of the change area.

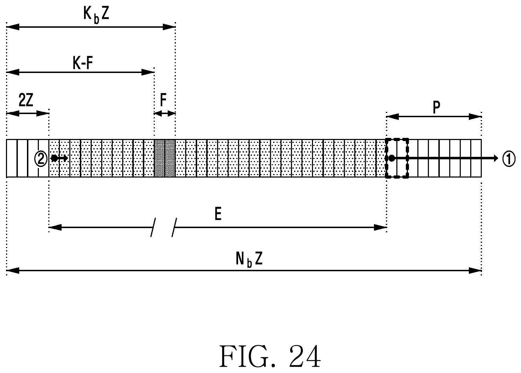

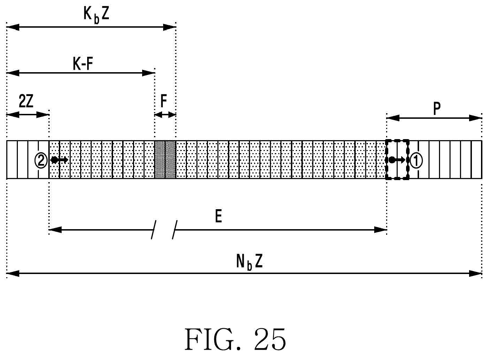

In FIG. 24 and FIG. 25, in a case that the intrinsic LLR sequence does not include an LLR for the systematic puncturing bit, a search range of the LLR at which the value may be changed is specifically illustrated. Since FIG. 24 has the same operation of the parity part as FIG. 22, but the systematic puncturing bit does not exist, in this case, a change area of the LLR may be determined according to Equation 15. ${S}_{i} = 2 Z + \left(\left(E+F+i\right) mod \left({N}_{b}-2\right)Z\right) for i = 0 , 1 , … , q - 1$

S*ᵢ* indicates the bit index of the i-th position in the change area. N_{b}Z may correspond to the code length N. Z may correspond to the lifting size for the LDPC code. E indicates the number of bits (e.g., the number of bits transmitted through the wireless channel) according to the code rate matching, and F indicates the number of bits shortened according to the zero filling (e.g., the zero filling 530). q indicates the size of the change area.

FIG. 25 corresponds to a case that the systematic puncturing bit and all punctured parity bits are not included, and an LLR change area may be determined according to Equation 16. ${S}_{i} = 2 Z + \left(\left(E+F+i\right)mod\left(\left⌈\frac{E + F}{Z}\right⌉\times Z\right)\right) for i = 0 , 1 , … , q - 1$

S*ᵢ* indicates the bit index of the i-th position in the change area. N_{b}Z may correspond to the code length N. Z may correspond to the lifting size for the LDPC code. E indicates the number of bits (e.g., the number of bits transmitted through a wireless channel) according to the code rate matching, and F indicates the number of bits shortened according to the zero filling (e.g., the zero filling 530). q indicates the size of the change area.

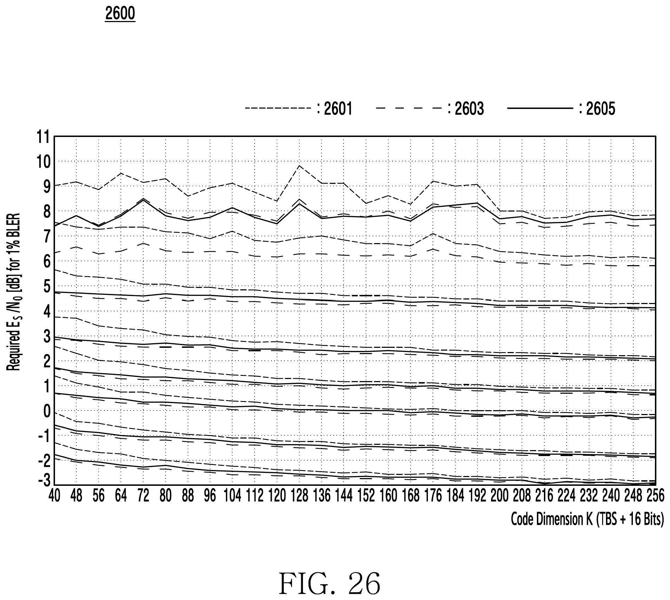

FIG. 26 illustrates an example of a performance of ensemble decoding using signal extension. In FIG. 26, a result of evaluating an error-correction performance of a method for determining a position of an LLR to change a value based on an AP-LLR sequence proposed above and an embodiment of the present disclosure according to a code dimension and a code rate in a 5G NR LDPC code system is illustrated.

Referring to FIG. 26, a graph 2600 indicates error-correction performances for each code dimension. A horizontal axis of the graph 2600 indicates a code dimension *K*, and a vertical axis of the graph 2600 indicates *Eₛ*/*N*₀ dB value which is a signal-to-noise ratio (SNR) to achieve a required block error rate (BLER) 1%. For this experimental result, BLER values are measured by equally applying a QPSK modulation scheme in an AWGN channel. As *E*ₛ/*N*₀ required to achieve the BLER 1% which is a value of a Y-axis becomes smaller, a better error-correction performance is indicated.

The graph 2600 includes an experimental result at various code rates. For example, the graph 2600 may include an error-correction performance of general decoding 2601 which is not ensemble decoding, an error-correction performance of ensemble decoding 2603 according to a third example 1630 of the third scheme, and an error-correction performance of ensemble decoding 2605 according to the fourth scheme. Each curve indicates the *Eₛ*/*N*₀ value for code parameters having the same code rate. A decoder according to a method for determining (i.e., the third scheme) the position of the LLR to change the value based on the AP-LLR sequence finds *q* = 3 LLR positions having low absolute values in the AP-LLR sequence. A decoder according to an ensemble decoding method according to the fourth scheme may determine *q* = 3 punctured positions in punctured parts of the parity bit. For example, the decoder may determine the position to change the LLR value by using one of the [Equation 13] to the [Equation 16]. For example, a decoder according to the third scheme generates 2*^{q}* = 8 modified candidate LLR sequences by changing a value at corresponding positions of the intrinsic LLR to all possible patterns and attempts decoding. On the other hand, a decoder according to the fourth scheme preserves the given intrinsic LLR value as it is and generates 2*^{q}* = 8 modified candidate LLR sequences at a selected position among the punctured bits. Each determination method differently sets a search range and an area for finding the position of the LLRs to change the value.

As illustrated in FIG. 26, according to the fourth scheme, a method considering a small search range may achieve the error-correction performance similar to a method considering a search range by using the AP-LLR sequence according to the third scheme. That is, although decoding performances are similar, since there is no comparison operation of LLR values for determining the change area, the fourth scheme may be advantageous in terms of reduction of a delay time due to decoding and reduction of implementation complexity.

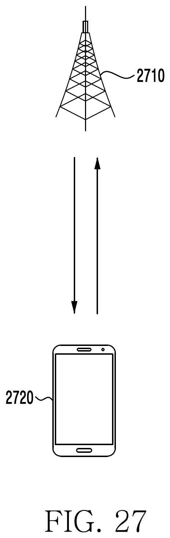

FIG. 27 illustrates an example of a wireless communication system.

Referring to FIG. 27, FIG. 27 illustrates a base station 2710 and a terminal 2720, as a portion of nodes using a wireless channel in the wireless communication system. FIG. 27 illustrates only one base station, but the wireless communication system may further include another base station that is identical to or similar to the base station 2710. As an example, the base station 2710 may correspond to a transmission device 500, and the terminal 2720 may correspond to a reception device 600. As another example, the base station 2710 may correspond to the reception device 600, and the terminal 2720 may correspond to the transmission device 500.

The base station 2710 is a network infrastructure providing a wireless access to the terminal 2720. The base station 2710 has a coverage defined based on a distance at which a signal may be transmitted. In addition to the base station, the base station 2710 may be referred to as an access point (AP), a RAN node, an eNodeB (eNB), a 5th generation node (5G node), a next generation nodeB (gNB), a wireless point, a transmission/reception point (TRP), a communication node, a wireless communication device, a wireless communication equipment, a network node, a network entity, or another term having a technical meaning equivalent thereto.

The terminal 2720 is a device used by a user, and performs communication with the base station 2710 through the wireless channel. A link from the base station 2710 to the terminal 2720 is referred to as a downlink (DL), and a link from the terminal 2720 to the base station 2710 is referred to as an uplink (UL). In addition, although not illustrated in FIG. 27, the terminal 2720 and another terminal may perform communication with each other through the wireless channel. In this case, a link between the terminal 2720 and the another terminal is referred to as a device-to-device link (D2D), and the sidelink may be interchangeably used with a PC5 interface. In another some embodiments, the terminal 2720 may be operated without a user involvement. According to an embodiment, the terminal 2720 is a device performing a machine type communication (MTC), and may not be carried by the user. In addition, according to an embodiment, the terminal 2720 may be a narrowband (NB)-internet of things (IoT) device.

In addition to the terminal, the terminal 2720 may be referred to as a user equipment (UE), a customer premises equipment (CPE), a mobile station, a subscriber station, a remote terminal, a wireless terminal, an electronic device, or a user device, or another term having a technical meaning equivalent thereto.

The base station 2710 may perform beamforming with the terminal 2720. The base station 2710 and the terminal 2720 may transmit and receive a radio signal in a relatively low frequency band (e.g., a frequency range 1 (FR 1) of NR). In addition, the base station 2710 and the terminal 2720 may transmit and receive a radio signal in a relatively high frequency band (e.g., FR 2 (or, FR 2-1, FR 2-2, FR 2-3), FR 3 of the NR, or a mmWave band (e.g., 26 GHz, 28 GHz, 30 GHz, 38 GHz, 60 GHz)). In order to improve a channel gain, the base station 2710 and the terminal 2720 may perform the beamforming. Herein, the beamforming may include transmission beamforming and reception beamforming. The base station 2710 and the terminal 2720 may impart a directivity to a transmission signal or a reception signal. For this, the base station 2710 and the terminal 2720 may select serving beams through a beam search or a beam management procedure. After the serving beams are selected, a subsequent communication may be performed through a resource having a QCL relation with a resource transmitting the serving beams.

If large-scale characteristics of a channel that has transmitted a symbol on a first antenna port may be inferred from a channel that has transmitted a symbol on a second antenna port, the first antenna port and the second antenna port may be evaluated as being in the QCL relation. For example, the large-scale characteristics may include at least one of a delay spread, a doppler spread, a doppler shift, an average gain, an average delay, or a spatial receiver parameter.

In FIG. 27, both the base station 2710 and the terminal 2720 are described as performing beamforming, but embodiments of the present disclosure are not necessarily limited thereto. In some embodiments, the terminal may perform beamforming or may not perform beamforming. In addition, the base station may perform beamforming or may not perform beamforming. That is, only one of the base station and the terminal may perform beamforming, or both the base station and the terminal may not perform beamforming.

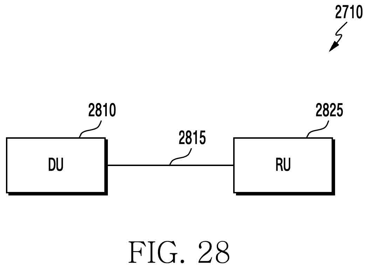

FIG. 28 illustrates network entities according to a distributed deployment. For example, the network entities may include a digital unit (DU) and a radio unit (RU) 2820 (or a massive multiple input multiple output unit (MMU)). For example, the network entities may be connected through a fronthaul. The fronthaul refers to, unlike a backhaul between a base station and a core network, entities (e.g., a DU 2810 and a RU 2820) between a wireless LAN and the base station. FIG. 28 illustrates an example of a fronthaul structure between one DU 2810 and one RU 2820, but this is merely for convenience of description and the present disclosure is not limited thereto. In other words, an embodiment of the present disclosure may also be applied to a fronthaul structure between one DU and a plurality of RUs. For example, an embodiment of the present disclosure may be applied to a fronthaul structure between one DU and two RUs. In addition, an embodiment of the present disclosure may be applied to a fronthaul structure between one DU and three RUs.

Referring to FIG. 28, the base station 2710 may include the DU 2810 and the RU 2820. A fronthaul 2815 between the DU 2810 and the RU 2820 may be operated through an Fx interface. For operation of the fronthaul 2815, for example, an enhanced common public radio interface (eCPRI) and a radio over ethernet (ROE) may be used. According to an implementation example, In addition to the (digital unit) DU, the DU 2810 may be referred to as a baseband unit (BBU), a digital BBU, a baseband digital unit, a processing unit, digital processing circuitry, baseband processing circuitry, a baseband processing unit, and/or another term having a technical meaning equivalent thereto. According to an implementation example, in addition to the (radio unit) RU, the RU 2820 may be referred to as a remote unit, a radio demote head (RRH), radio processing circuitry, a radio processing unit, an antenna integrated radio, an air radio device, an air scale communication device, a radio device, a wireless communication device, and/or another term having a technical meaning equivalent thereto. In addition, according to an implementation example, in the present disclosure, a network entity connected to the DU 2810 is described as the RU 2820, but instead of the RU 2820, the massive multiple input multiple output unit (MMU) may also be connected to the DU 2810 and used.

As a communication technology is developed, a mobile data traffic increases, and accordingly, a bandwidth requirement required in a fronthaul between a digital unit and a radio unit has greatly increased. In a deployment such as a centralized/cloud radio access network (C-RAN), the DU may perform functions for a packet data convergence protocol (PDCP), a radio link control (RLC), a media access control (MAC), and a physical (PHY), and the RU may be implemented to further perform functions for a PHY layer in addition to a radio frequency (RF) function. The DU 2810 may be responsible for upper layer functions of a wireless network.

For example, the DU 2810 may perform a function of the MAC layer and a portion of the PHY layer. Herein, the portion of the PHY layer refers to being performed at a relatively higher stage among functions of the PHY layer, and, as an example, may include channel encoding (or channel decoding), scrambling (or descrambling), modulation (or demodulation), and layer mapping (or layer demapping). According to an embodiment, in a case that the DU 2810 follows an O-RAN specification, the DU 2810 may be referred to as an O-DU. The DU 2810 may be replaced and represented as a first network entity for a base station (e.g., a gNB) in embodiments of the present disclosure, as necessary. The RU 2820 may be responsible for lower layer functions of a wireless network. For example, the RU 2820 may perform a portion of the PHY layer and an RF function. Herein, the portion of the PHY layer refers to being performed at a relatively lower stage than the DU 2810 among the functions of the PHY layer, and, as an example, may include an iFFT transform (or an FFT transform), CP insertion (CP removal), and digital beamforming. The RU 2820 may be referred to as an access unit (AU), an access point (AP), a transmission/reception point (TRP), a remote radio head (RRH), a radio unit (RU), or another term having a technical meaning equivalent thereto. According to an embodiment, in a case that the RU 2820 follows the O-RAN specification, the RU 2820 may be referred to as an O-RU. The RU 2820 may be replaced and represented as a second network entity for the base station (e.g., the gNB) in embodiments of the present disclosure, as necessary.

In FIG. 28, the base station 2710 is described as including the DU 2810 and the RU 2820, but embodiments of the present disclosure are not limited thereto. The base station according to embodiments may be implemented as a distributed deployment according to a centralized unit (CU) configured to perform functions (e.g., a packet data convergence protocol (PDCP), a radio resource control (RRC)) of upper layers of an access network and a distributed unit (DU) configured to perform functions of lower layers. As an example, the digital unit (DU) 2810 may be implemented by being separated into the CU and the DU. Between a core network (e.g., a 5G core (5GC) or a next generation core (NGC)) and a radio access network (RAN), the base station may be implemented as a structure in which the CU, the DU, and the RU are arranged in order. An interface between the CU and the distributed unit (DU) may be referred to as an F1 interface.

The centralized unit (CU) may be connected to one or more DUs and may be responsible for functions of upper layers than the DU. For example, the CU may be responsible for functions of the radio resource control (RRC) and the packet data convergence protocol (PDCP), and the DU and the RU may be responsible for functions of lower layers. The DU may perform a portion of functions (high PHY) of the radio link control (RLC), the media access control (MAC), and the physical (PHY) layer, and the RU may be responsible for remaining functions (low PHY) of the PHYlayer. In addition, as an example, the digital unit (DU) may be included in the distributed unit (DU) according to a distributed deployment implementation of the base station. Hereinafter, unless separately defined, operations of the digital unit (DU) and the RU are described, but various embodiments of the present disclosure may be applied to both a base station deployment including the CU or a deployment in which the DU is directly connected to the core network (that is, the CU and the DU are implemented by being integrated into one entity of a base station (e.g., an NG-RAN node)).

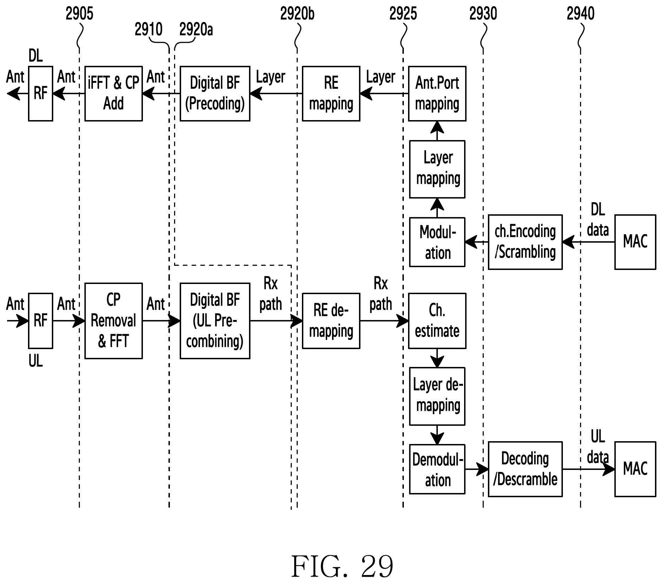

According to an embodiment, a node performing LDPC decoding in a reception device 600 according to embodiments of the present disclosure may be the DU 2810, the RU 2820, and/or another node (e.g., the MMU, the BBU). According to which node performs a channel decoding block, a function split of the distributed deployment may be defined in various ways, and a detailed description thereof is described with reference to FIG. 29. As a device for decoding an uplink signal according to LDPC encoding, the reception device 600 may be the DU 2810, the RU 2820, and/or the another node (e.g., the MMU, the BBU).

FIG. 29 illustrates an example of a function split of network entities. As a wireless communication technology is developed (e.g., introduction of a 5th generation (5G) communication system (or a new radio (NR) communication system)), a used frequency band has further increased. As a cell radius of a base station becomes very small, the number of RUs required to be installed has further increased. In addition, in the 5G communication system, an amount of data to be transmitted has greatly increased by up to 10 times or more, and a transmission capacity of a wired network transmitted to a fronthaul has greatly increased. Due to the above-described factors, installation cost of the wired network in the 5G communication system may greatly increase. Accordingly, in order to reduce the transmission capacity of the wired network and to reduce the installation cost of the wired network, a function split in which a portion of functions of a modem of a DU are transferred to a RU to reduce a transmission capacity of the fronthaul may be used. Hereinafter, although described as the RU, the function split described below may be equally applied not only to the RU but also to a relationship between a MMU and the DU.

In order to reduce a burden of the DU, a role of the RU that is responsible for only an RF function may be extended to a portion of functions of a physical layer. As the RU performs functions of higher layers, a throughput of the RU increases so that a transmission bandwidth in the fronthaul increases and, at the same time, a constraint of a latency requirement due to a response processing may be reduced. On the other hand, as the RU performs functions of higher layers, a virtualization gain decreases, and a size, a weight, and a cost of the RU increase. Considering a trade-off of the above-described advantages and disadvantages, implementing an optimal function split is required.

Referring to FIG. 29, function splits in the physical layer below a MAC layer are illustrated. In a case of a downlink (DL) in which a signal is transmitted to a terminal through a wireless network, the base station may sequentially perform channel encoding/scrambling, modulation, layer mapping, antenna mapping, RE mapping, digital beamforming (e.g., precoding), iFFT transform/CP insertion, and RF transform. In a case of an uplink (UL) in which a signal is received from the terminal through the wireless network, the base station may sequentially perform RF transform, FFT transform/CP removal, digital beamforming (pre-combining), RE demapping, channel estimation, layer demapping, demodulation, and decoding/descrambling. A split for uplink functions and downlink functions may be defined in various types according to necessity between vendors and a discussion in a standard, according to the above-described trade-off.

In a first function split 2905, the RU performs the RF function, and the DU performs the PHY function. The first function split is that a PHY function in the RU is not substantially implemented, and, as an example, may be referred to as Option 8. In a second function split 2910, the RU performs iFFT transform/CP insertion in the DL of the PHY function and FFT transform/CP removal in the UL, and the DU performs remaining PHY functions. As an example, the second function split 2910 may be referred to as Option 7-1. In a third function split 2920a, the RU performs iFFT transform/CP insertion in the DL of the PHY function and FFT transform/CP removal and digital beamforming in the UL, and the DU performs remaining PHY functions. As an example, the third function split 2920a may be referred to as Option 7-2x Category A. In a fourth function split 2920b, the RU performs up to digital beamforming in both the DL and the UL, and the DU performs upper PHY functions after the digital beamforming. As an example, the fourth function split 2920b may be referred to as Option 7-2x Category B. In a fifth function split 2925, the RU performs up to RE mapping (or RE demapping) in both the DL and the UL, and the DU performs upper PHY functions after the RE mapping (or RE demapping). As an example, the fifth function split 2925 may be referred to as Option 7-2. In a sixth function split 2930, the RU performs up to modulation (or demodulation) in both the DL and the UL, and the DU performs upper PHY functions after the modulation (or demodulation). As an example, the sixth function split 2930 may be referred to as Option 7-3. In a seventh function split 2940, the RU performs up to encoding/scrambling (or decoding/descrambling) in both the DL and the UL, and the DU performs upper PHY functions after modulation (or demodulation). As an example, the seventh function split 2940 may be referred to as Option 6.

According to an embodiment, in a case that large-capacity signal processing is expected such as an FR 1 MMU, a function split (e.g., the fourth function split 2920b) in a relatively higher layer may be required in order to reduce a fronthaul capacity. In addition, a function split (e.g., the sixth function split 2930) in a too high layer causes a control interface to be complicated, and since a plurality of PHY processing blocks are included in the RU, may cause a burden in implementation of the RU, and therefore, an appropriate function split may be required according to a deployment and an implementation method of the DU and the RU.

According to an embodiment, in a case that precoding of the data received from the DU cannot be processed (i.e., in a case that a capability of precoding of the RU has a limitation), the third function split 2920a or a function split (e.g., the second function split 2910) equal to or lower than the third function split 2920a may be applied. Conversely, in a case that there is a capability to process precoding of the data received from the DU, the fourth function split 2920b or a function split (e.g., the sixth function split 2930) equal to or higher than the fourth function split 2920b may be applied.

In an O-RAN specification, a type of an O-RU is distinguished according to whether a precoding function is located at an interface of an O-DU or located at an interface of the O-RU. For example, the RU may perform operations according to a function split of the third function split 2920a (which may be referred to as a category A (CAT-A)) or the fourth function split 2920b (which may be referred to as a category B (CAT-B)). In other words, an O-RU in which precoding is not performed (i.e., complexity is low) may be referred to as a CAT-A O-RU. An O-RU in which precoding is performed may be referred to as a CAT-B O-RU. In addition, for example, a channel estimation may also be performed in the O-RU instead of the O-DU. In order to improve an uplink performance, the O-RU may operate according to the sixth function split 2930 (Option 7-3).

Hereinafter, an upper-PHY refers to physical layer processing processed in the DU of a fronthaul interface. For example, the upper-PHY may include FEC encoding/decoding, scrambling, and modulation/demodulation. Hereinafter, a lower-PHY refers to physical layer processing processed in the RU of the fronthaul interface. For example, the lower-PHY may include FFT/iFFT, digital beamforming, and extraction and filtering of a physical random access channel (PRACH). However, the above-described criteria do not exclude embodiments through other function splits. A functional configuration, signaling, or an operation of FIG. 5 to FIG. 14B described below may be applied not only to the third function split 2920a and the fourth function split 2920b but also to another function split (e.g., the sixth function split 2930).

In FIG. 29, in a case of a function split between the DU and the RU, an channel estimation may also be performed in the O-RU instead of the O-DU. In order to improve the uplink performance, the O-RU may operate according to the sixth function split 2930 (Option 7-3).

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among the first input sequence based on a lifting size for the channel code and the number of bits to be encoded in a code block, obtain second candidate input sequences corresponding to combinations having different values in the change area of the first input sequence as a reference of the first input sequence, and provide a final decoding result by decoding each candidate input sequence from at least a portion of the second candidate input sequences.

For example, the change area may be determined in accordance with a magnitude of a log likelihood ratio (LLR) value at a corresponding position of the first input sequence within a search range. A size of the search range may be determined based on the number of bits to be encoded in the code block, the number of filling bits shortened for transmission of the signal, and the number of systematic puncturing bits corresponding to two times of the lifting size.

For example, the search range may correspond to positions of bits from a next position of the systematic puncturing bits corresponding to the two times of the lifting size, the bits remaining after excluding the filling bits from among the bits to be encoded in the code block.

For example, the search range may correspond to positions of bits from a start position of the code block, the bits remaining after excluding the filling bits and the systematic puncturing bits corresponding to the two times of the lifting size from among the bits to be encoded in the code block.

For example, the channel code may comprise a low density parity check (LDPC) code. The lifting size may be determined based on an index associated with a parity check matrix of the LDPC code. The number of bits to be encoded in the code block may be determined based on a base graph of the LDPC code and the lifting size.

For example, the first input sequence may indicate an intrinsic log-likelihood ratio (LLR) estimated before a variable node (VN) update and a check node (CN) update according to belief-propagation.

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among a systematic part and a parity part of the first input sequence based on a result of decoding of belief-propagation for the first input sequence, obtain second candidate input sequences corresponding to combinations having different values in the change area of the first input sequence as a reference of the first input sequence, and provide a final decoding result by decoding each candidate input sequence from at least a portion of the second candidate input sequences.

According to an embodiment, the change area may be determined in accordance with a magnitude of a log likelihood ratio (LLR) value at a corresponding position of a sequence according to the result of the decoding, within a search range. The search range may include systematic puncturing bits.

For example, the search range may correspond to positions of bits updated through a variable node (VN) update and a check node (CN) update according to the belief propagation.

For example, the search range may correspond to positions of bits the bits remaining after excluding filling bits shortened for transmission of the signal from the systematic part corresponding to the number of bits to be encoded in the code block.

For example, the search range may correspond to positions of systematic puncturing bits corresponding to two times of the lifting size in the systematic part corresponding to the number of bits to be encoded in the code block.

For example, the channel code may comprise a low density parity check (LDPC) code. The systematic part and the parity part may be determined based on a lifting size for the LDPC code and a base graph of the LDPC code.

For example, the first input sequence may indicate an intrinsic log-likelihood ratio (LLR) estimated before a variable node (VN) update and a check node (CN) update according to the belief propagation. The result of the decoding for the first input sequence may indicate a posteriori LLR after the VN update and the CN update according to the belief propagation.

In embodiments, an electronic device in a communication system or a broadcasting system is provided. The electronic device may comprise at least one processor, and memory storing instructions. The instructions, when executed by the at least one processor, may cause the electronic device to obtain a signal encoded through a channel code, obtain a first input sequence for the signal, determine a change area among puncturing bits of a systematic part and puncturing bits of a parity part of the first input sequence, obtain second candidate input sequences corresponding to combinations having different values in the change area of the first input sequence as a reference of the first input sequence, and provide a final decoding result by decoding each candidate input sequence from at least a portion of the second candidate input sequences.

For example, the change area may be determined in accordance with a magnitude of a log likelihood ratio (LLR) value at a corresponding position of the first input sequence within a search range. The search range may correspond to the positions of at least a portion of the punctured bits of the parity part and may not correspond to the positions of the puncturing bits of the systematic part.

For example, the search range may correspond to the positions of at least a portion of the puncturing bits of the systematic part, and may not correspond to the positions of the puncturing bits of the parity part.

For example, the number of second candidate input sequences may be determined as a power of 2 according to the number of bit indices corresponding to the change area.

For example, the search range may be different from an area of bits transmitted through a wireless channel among an entire encoding area for the channel code.

For example, the channel code may comprise a low density parity check (LDPC) code. The systematic part and the parity part may be determined based on a lifting size for the LDPC code and a base graph of the LDPC code.

For example, the first input sequence may indicate an intrinsic log-likelihood ratio (LLR) estimated before a variable node (VN) update and a check node (CN) update according to the belief propagation.

In embodiments, a decoding method for a channel code in a communication system is provided. The method may comprise a step of receiving a signal encoded with a channel code that is used, and transmitted, a step of generating a first decoder input sequence (or a vector, an array, and the like) from the signal, a step of generating at least one or more modified second decoder input sequences by changing one or more elements in the first decoder input sequence, a step of performing decoding on each of the at least one or more modified second decoder input sequences, and a step of determining a final decoding result based on results of the decoding performed on each of the at least one or more modified second decoder input sequences, and wherein at least one or more elements to be changed in the first decoder input sequence may be selected from a limited area determined in consideration of a structure of the channel code.

In embodiments, a decoding method for a channel code in a communication system is provided. The method may include a step of receiving a signal encoded with a channel code that is used, and transmitted, a step of generating a first decoder input sequence (or a vector, an array, and the like) from the signal, a step of performing decoding on the first decoder input sequence, a step of checking a second decoder output sequence generated or updated by the decoding, a step of checking or determining one or more element positions based on the second decoder output sequence, a step of generating at least one or more modified third decoder input sequences by changing at least one or more elements of the first decoder input sequence based on the element positions checked or determined based on the second decoder output sequence, a step of performing decoding on each of the at least one or more modified third decoder input sequences, and a step of determining a final decoding result based on results of the decoding performed on each of the at least one or more modified third decoder input sequences.

In embodiments, a decoding method for a channel code in a communication system is provided. The method may include a step of receiving a signal encoded with a channel code that is used, and transmitted, a step of generating a first decoder input sequence (or a vector, an array, and the like) from the signal, a step of generating at least one or more modified second decoder input sequences by adding one or more elements in the first decoder input sequence, a step of performing decoding on each of the at least one or more modified second decoder input sequences, and a step of determining a final decoding result based on results of the decoding performed on each of the at least one or more modified second decoder input sequences. At least one or more elements to be changed in the first decoder input sequence may be selected from a limited area determined in consideration of a structure of the channel code.

The present disclosure aims to improve decoding performance of a channel code in which a posterior probability, a posteriori log-likelihood ratio (AP-LLR), and the like of codeword bits are gradually updated through iterative processing, such as a turbo code and a low-density parity-check code (LDPC code), in a communication or a broadcasting system. In theory, the channel code has low error-correction performance when a code dimension (the number of information bits to be encoded, an encoder input length) and a code length (the number of codeword bits obtained by encoding, an encoder output length) are short. Specifically, even when a code rate (a ratio of the code dimension and the code length) is the same, an error-correction performance when the code dimension and the code length are short is lower than an error-correction performance when the code dimension and the code length are long. In addition, the turbo code and the LDPC code have a characteristic that the performance is more significantly degraded when the code dimension and the code length are short. Accordingly, the present disclosure considers, as a problem to be solved, effectively improving a low error-correction performance occurring when the dimension and the length of the channel code, such as the turbo code and the LDPC code, are short. Specifically, various embodiments of the present disclosure have a main objective of achieving a better error-correction performance than conventional methods through simpler operations for the turbo code and the LDPC codes having the short code dimensions and the code length.

An embodiment of a decoding method of a channel code performed by a receiver in the communication and the broadcasting system of the present disclosure includes a step of receiving a signal encoded with a channel code that is used, and transmitted, a step of generating an original decoder input sequence (or a vector, an array, and the like), such as a log-likelihood ratio (LLR) sequence, from the signal, a step of generating at least one or more modified decoder input sequences by changing at least one element in the original decoder input sequence, a step of performing decoding based on each of the at least one or more modified decoder input sequences, a step of determining a final decoding result based on results obtained from the decoding performed for each of the at least one or more modified decoder input sequences, and wherein at least one element to be changed in the original decoder input sequence is determined from a limited range determined based on a structure and a characteristic of the channel code used.

An embodiment of a decoding method of a channel code performed by a receiver in a communication and a broadcasting system of the present disclosure includes a step of receiving a signal encoded with a channel code that is used, and transmitted, a step of generating an original decoder input sequence (or a vector, an array, and the like), such as a log-likelihood ratio (LLR) sequence, from the signal, a step of performing decoding based on the original decoder input sequence, a step of obtaining a decoder output sequence generated in a decoder in a case that the decoding based on the original decoder input sequence fails, a step of determining a position at which a value of at least one element is to be changed based on the decoder output sequence, a step of generating at least one or more modified decoder input sequences by changing at least one element among elements of the original decoder input sequence based on the position of the element of which the value is to be changed, a step of performing decoding based on each of the at least one or more modified decoder input sequences, and a step of determining a final decoding result based on results obtained from the decoding performed for each of the at least one or more modified decoder input sequences.

A decoding device and method according to various embodiments of the present disclosure generate at least two modified decoder input sequences based on an original decoder input sequence, perform decoding based on each, and then combine results to greatly improve a decoding performance. In particular, the decoding device and method according to various embodiments of the present disclosure reduce complexity by searching a smaller range than a conventional decoding method and device in determining an element to be changed in the original decoder input sequence. Accordingly, various embodiments of the present disclosure achieve an almost similar level of an error-correction performance while minimizing additional complexity and latency compared to a conventional method in generating modified decoder input sequences.

A decoding device and method according to various embodiments of the present disclosure generate at least two modified decoder input sequences based on an original decoder input sequence, perform decoding based on each, and then combine results to greatly improve a decoding performance. In particular, the decoding device and method according to various embodiments of the present disclosure are based on a decoder output sequence obtained after one decoding in determining an element to be changed in the original decoder input sequence. Various embodiments of the present disclosure achieve a better error-correction performance while reducing complexity and latency compared to a conventional method, in a method of modifying a decoder input sequence based on the decoder output sequence.

The effects that can be obtained from the present disclosure are not limited to those described above, and any other effects not mentioned herein will be clearly understood by those having ordinary knowledge in the art to which the present disclosure belongs, from the following description.

For one or more embodiments, at least one of components described in one or more of the preceding drawings may be configured to perform one or more operations, techniques, processes, and/or methods as described in the present disclosure. For example, a processor (e.g., a baseband processor) described in the present disclosure in association with one or more of the preceding drawings may be configured to operate according to one or more examples described in the present disclosure. As another example, circuitry associated with a user equipment (UE), a base station, a network element, and the like as described above in association with one or more of the preceding drawings, may be configured to operate according to one or more examples described herein.

Any of the embodiments described above may be combined with any other embodiment (or a combination of embodiments) unless explicitly stated otherwise. The foregoing description of one or more implementations is provided for illustration and description, and is not intended to limit the scope of the embodiments or to be exhaustive to the precise forms disclosed. Modifications and variations are possible in light of the above teachings or may be obtained from practice of various embodiments.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An electronic device in a communication system or a broadcasting system, the electronic device comprising:
at least one processor; and
memory storing instructions that, when executed by the at least one processor, cause the electronic device to:
obtain a signal encoded through a channel code;
obtain a first input sequence for the signal;
determine a change area among the first input sequence based on a lifting size for the channel code and the number of bits to be encoded in a code block,
obtain second candidate input sequences corresponding to combinations having different values in the change area of the first input sequence as a reference of the first input sequence; and
provide a final decoding result by decoding each candidate input sequence from at least a portion of the second candidate input sequences.

2. The electronic device of claim 1,
wherein the change area is determined in accordance with a magnitude of a log likelihood ratio (LLR) value at a corresponding position of the first input sequence within a search range, and
wherein a size of the search range is determined based on the number of bits to be encoded in the code block, the number of filling bits shortened for transmission of the signal, and the number of systematic puncturing bits corresponding to two times of the lifting size.

3. The electronic device of claim 2,
wherein the search range corresponds to positions of bits from a next position of the systematic puncturing bits corresponding to the two times of the lifting size, the bits remaining after excluding the filling bits from among the bits to be encoded in the code block.

4. The electronic device of claim 2,
wherein the search range corresponds to positions of bits from a start position of the code block, the bits remaining after excluding the filling bits and the systematic puncturing bits corresponding to the two times of the lifting size from among the bits to be encoded in the code block.

5. The electronic device of claim 1,
wherein the channel code comprises a low density parity check (LDPC) code,
wherein the lifting size is determined based on an index associated with a parity check matrix of the LDPC code, and
wherein the number of bits to be encoded in the code block is determined based on a base graph of the LDPC code and the lifting size.

6. The electronic device of claim 1, wherein the first input sequence indicates an intrinsic log-likelihood ratio (LLR) estimated before a variable node (VN) update and a check node (CN) update according to belief-propagation.

7. An electronic device in a communication system or a broadcasting system, the electronic device comprising:
at least one processor; and
memory storing instructions that, when executed by the at least one processor, cause the electronic device to:
obtain a signal encoded through a channel code;
obtain a first input sequence for the signal;
determine a change area among a systematic part and a parity part of the first input sequence based on a result of decoding of belief-propagation for the first input sequence;
obtain second candidate input sequences corresponding to combinations having different values in the change area of the first input sequence as a reference of the first input sequence; and
provide a final decoding result by decoding each candidate input sequence from at least a portion of the second candidate input sequences.

8. The electronic device of claim 7,
wherein the change area is determined in accordance with a magnitude of a log likelihood ratio (LLR) value at a corresponding position of a sequence according to the result of the decoding, within a search range and
wherein the search range includes systematic puncturing bits.

9. The electronic device of claim 8,
wherein the search range corresponds to positions of bits updated through a variable node (VN) update and a check node (CN) update according to the belief propagation.

10. The electronic device of claim 8,
wherein the search range corresponds to positions of bits the bits remaining after excluding filling bits shortened for transmission of the signal from the systematic part corresponding to the number of bits to be encoded in the code block.

11. The electronic device of claim 8,
wherein the search range corresponds to positions of systematic puncturing bits corresponding to two times of the lifting size in the systematic part corresponding to the number of bits to be encoded in the code block.

12. The electronic device of claim 7,
wherein the channel code comprises a low density parity check (LDPC) code, and wherein the systematic part and the parity part are determined based on a lifting size for the LDPC code and a base graph of the LDPC code.

13. The electronic device of claim 7,
wherein the first input sequence indicates an intrinsic log-likelihood ratio (LLR) estimated before a variable node (VN) update and a check node (CN) update according to the belief propagation, and
wherein the result of the decoding for the first input sequence indicates a posteriori LLR after the VN update and the CN update according to the belief propagation.

14. An electronic device in a communication system or a broadcasting system, the electronic device comprising:
at least one processor; and
memory storing instructions that, when executed by the at least one processor, cause the electronic device to:
obtain a signal encoded through a channel code;
obtain a first input sequence for the signal;
determine a change area among puncturing bits of a systematic part and puncturing bits of a parity part of the first input sequence;
obtain second candidate input sequences corresponding to combinations having different values in the change area of the first input sequence as a reference of the first input sequence; and
provide a final decoding result by decoding each candidate input sequence from at least a portion of the second candidate input sequences.

15. The electronic device of claim 14,
wherein the change area is determined in accordance with a magnitude of a log likelihood ratio (LLR) value at a corresponding position of the first input sequence within a search range, and
wherein the search range corresponds to the positions of at least a portion of the punctured bits of the parity part and does not correspond to the positions of the puncturing bits of the systematic part.
